(19) Europäisches Patentamt
European Patent Office
Office européen des brevets

(11) Publication number : **0 238 267 B1**

(12) # EUROPEAN PATENT SPECIFICATION

(45) Date of publication of patent specification : **31.05.95 Bulletin 95/22**

(51) Int. Cl.$^6$ : **H05K 9/00,** H05K 1/02, H05K 3/46, C09D 5/00

(21) Application number : **87302165.3**

(22) Date of filing : **13.03.87**

(54) **Printed circuit board capable of preventing electromagnetic interference.**

(30) Priority : **13.03.86 JP 56714/86**
**13.06.86 JP 138889/86**
**08.07.86 JP 160364/86**
**08.07.86 JP 160365/86**

(43) Date of publication of application : **23.09.87 Bulletin 87/39**

(45) Publication of the grant of the patent : **31.05.95 Bulletin 95/22**

(84) Designated Contracting States : **DE FR GB IT SE**

(56) References cited :
**DE-A- 1 930 642**
**DE-A- 1 936 899**
**DE-A- 2 558 367**
**US-A- 3 876 822**
**ELECRONIC DESIGN, vol. 33, no 3, 1985 February 7, Waseca, MN, USA, T. COSTLOW: "Conductice polymer inks may spell the future of multilayered boards", pages 53-55**
**PATENTS ABSTRACTS OF JAPAN,vol. 7, no 167, 22th July 1983, page 107 C 177; & JP-A-58-74759**
**IBM TECHNICAL DISCLOSURE BULLETIN, vol. 29, no. 2, July 1986: "Method for creating a stripline prototype"**

(73) Proprietor : **NINTENDO CO. LIMITED**
**60, Fukuine Kamitakamatsu-cho**
**Higashiyama-ku Kyoto (JP)**
Proprietor : **TATSUTA ELECTRIC WIRE & CABLE CO., LTD**
**3-1, Iwatacho 2-chome**
**Higashiosaka-shi**
**Osaka 578 (JP)**

(72) Inventor : **Nakagawa, Katsuya**
**Nintendo Co.,Ltd.**
**60 Fukuine Kamitakamatsu-cho**
**Higashiyama-ku Kyoto (JP)**
Inventor : **Eguchi, Kazumasa Tatsuta Electric Wire**
**Cable Co.,Ltd.3-1 Iwatacho 2-chome**
**Higashiosaka Osaka-fu (JP)**
Inventor : **Nakatani, Fumio Tatsuta Electric Wire**
**Cable Co.,Ltd.**
**3-1, Iwatacho 2-chome**
**Higashiosaka-shi Osaka-fu (JP)**
Inventor : **Wakita, Shinichi Tatsuta Electric Wire**
**Cable Co.,Ltd.**
**3-1, Iwatacho 2-chome**
**Higashiosaka-shi Osaka-fu (JP)**
Inventor : **Murakami, Hisatoshi Tatsuta Electric Wire**
**Cable Co.,Ltd.**
**3-1, Iwatacho 2-chome**
**Higashiosaka-shi Osaka-fu (JP)**
Inventor : **Terada, Tsunehiko Tatsuta Electric Wire**
**Cable Co.,Ltd.**
**3-1, Iwatacho 2-chome**
**Higashiosaka-shi Osaka-fu (JP)**

(74) Representative : **Read, Matthew Charles et al**
**Venner Shipley & Co.**
**20 Little Britain**
**London EC1A 7DH (GB)**

EP 0 238 267 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

## Description

The present invention relates to a printed circuit board capable of preventing electromagnetic interference and a method for its manufacture. More specifically, the present invention relates to a printed circuit board capable of preventing electromagnetic interference which is used in constructing electronic circuitry, for example, a domestic video game which is connected to another item of equipment by a cable and handles high-frequency signals.

In recent years regulations on electromagnetic interference such as those set by FCC (United States Federal Communication Committee) have become severe in every country. One example of an apparatus which can prevent such electromagnetic interference is disclosed in the JP-A-58-72895 published on May 15, 1983.

This prior art is very effective, for example, for personal computers and other self-standing equipment because a shield case is used to surround the whole unit. However, this is insufficient to prevent electromagnetic interference from domestic video games such as the Family Computer (registered trademark). The reason is that the video game unit is connected to other equipment, for example a TV receiver or a controller, through a long cable. This means that the above-described prior art does not prevent electromagnetic interference by confining electromagnetic energy in the shield case, being not effective for electromagnetic waves radiated from the cable extending from the video game.

Also, for example, in JP-A-56-8900 published on January 29, 1981, JP-A-59-20662 published on February 2, 1984 and JP-A-60-116437 published on June 22, various shield plates or shield sheets are disclosed which are considered to be effective for the above-described shield case. However, a problem similar to that in the above-described prior art is left even when such shield plates or shield sheets are used.

On the other hand, for example, in JP-A-57-4160 published on January 9, 1982, a semiconductor device, for example a charge transferring device, is disclosed wherein, to prevent electromagnetic radiation from a high frequency signal generating circuit, an electrically conductive layer is provided above that high frequency signal generating circuit on an insulating layer, and this electric conducting layer is held at a constant potential. In this prior art, electromagnetic radiation from a semiconductor chip itself is eliminated, but electromagnetic radiation from a printed pattern of a printed circuit board for mounting the chip thereon, that is, from a signal electrode portion of the printed circuit is not suppressed.

US-A-3876822 discloses a multilayer printed circuit board, wherein a base plate comprises a first signal conductive layer and a second continuous conductive layer covering the first layer and separated therefrom by insulating layers.

An object of the present invention is to provide a printed circuit board capable of preventing electromagnetic interference which can effectively suppress spurious radiation of electromagnetic waves from a signal electrode portion formed on a printed circuit board.

According to the present invention, there is provided a a printed circuit board for preventing emission of electromagnetic interference therefrom, comprising: an electrically insulating base plate having at least one main surface; a first electrically conductive layer formed on said main surface of said base plate, said first electrically conductive layer including a signal electrode portion in accordance with a desired circuit pattern; and a second electrically conductive layer formed so as to cover said first electrically conductive layer and being electrically insulated from said signal electrode portion, wherein said first conductive layer includes a ground electrode portion to which said second electrically conductive layer is connected, said second electrically conductive layer being arranged sufficiently close to the signal electrode portion of the first electrically conductive layer that electromagnetic energy generated in said signal electrode portion of said first electrically conductive layer is capacitively coupled to said second electrically conductive layer and from there passes into said ground electrode portion such that electromagnetic interference is inhibited from radiating within said printed circuit board.

The method of manufacturing such a printed circuit board is defined in claim 23.

In a conventional printed circuit board having no second electric conductive layer on the first electric conductive layer, stray capacitance or distributed capacitance is formed between adjacent signal electrodes in the first electric conductive layer. On the other hand, in the printed circuit board in accordance with the present invention, the second electric conductive layer is formed on the first electric conductive layer close thereto, and therefore each signal electrode of the first electric conductive layer forms a distributed capacitance between the second electric conductive layer close thereto rather than between the adjacent signal electrodes. This second electric conductive layer is connected to the ground electrode portion, therefore being grounded in respect of high frequency components. Accordingly, spurious electromagnetic energy produced in each signal electrode of the first electrically conductive layer, for example, by induction flows to ground through the distributed capacitance formed between the above-described second electrically conductive layer. Consequently, the spurious electromagnetic energy is eliminated in the printed circuit board itself.

In accordance with the present invention, spurious electromagnetic energy is reduced in the printed circuit board itself constituting an electronic circuit, and therefore, even if a cable or the like is connected to it, no electromagnetic wave is radiated through that cable. Accordingly, the present invention is very effective for preventing electromagnetic interference of all types of electronic equipment. More specifically, that in the measure for preventing electromagnetic interference using the shield case as is the case with the conventional one, spurious electromagnetic wave is eliminated in advance in the printed circuit board itself, and therefore spurious radiation can be stably prevented even when the cable or the like is connected thereto.

The second electrically conductive layer can be formed by printing a copper ink. Accordingly, the second electrically conductive layer can be formed very simply in comparison with the case where the second electrically conductive layer is formed with copper foil. Accordingly, the rise in the cost of the printed circuit board itself is reduced.

The copper ink to be used is made by mixing and kneading metallic copper powder, resin mixture and fatty acid or metallic salt thereof. The resin mixture acts as a binder of metallic copper powder and other components. For fatty acid acting as a dispersant, either of saturated fatty acid and unsaturated fatty acid may be used. Unsaturated fatty acid is preferably used. Further, a solvent of a reducing agent, an agent for adjusting coefficient of viscosity or the like may be added.

In one embodiment, the copper ink is made by blending 15 - 45 PHR in weight of mixture of resol type phenol resin and p-tert-butyl phenol resin and 0.5 - 7 PHR in weight of unsaturated fatty acid or alkali metallic salt thereof with 100 PHR in weight of metallic copper powder. When such a copper ink is used, no deterioration of electric conductivity is caused due to oxidation thereof, and the ink is stable with time.

For example, in JP-59-199778 published on november 12, 1984 and JP-60-156773 published on August 16, 1985, electrically conductive paints are disclosed. However, these conventional electrically conductive paints are not used for printed circuit boards, but are used to obtain an effect equivalent to the aforementioned shield case, shield plate or shield sheet by coating the housing portion with it. Accordingly, a printed circuit board in accordance with the present invention cannot be obtained by using these conventional paints.

In another embodiment, the copper ink is made by blending 15 - 50 PHR in weight of resin mixture (resin mixture composed of 20 - 60 weight percent of melamine resin and 80 - 40 weight percent of polyol and polyester resin and/or alkyd resin) and 1 - 8 PHR in weight of saturated fatty acid or unsaturated fatty acid or matallic salt thereof with 100 PHR in weight of metallic copper powder.

In still another embodiment, a metallic chelating agent and a soldering accelerating agent are further added to the copper ink, and a solder layer is formed on the second electric conductive layer formed by such a copper ink. As one example of the above-described copper ink, a copper ink is used which is made by blending 1 - 8 PHR in weight of saturated fatty acid or unsaturated fatty acid or metallic salt thereof, 1 - 50 PHR in weight of metallic chelating agent and 0.1 - 2.5 PHR in weight of soldering accelerating agent with a total of 100 PHR in weight of 85 - 95 weight percent of metallic copper powder and 15 - 5 weight percent of resin mixture (resin mixture composed of 2 - 30 weight percent of metal surface activating resin and the rest of the thermosetting resin).

By using the copper ink having the above-described composition, the electric conductivity is improved, and the whole surface of the cured copper ink layer can be tinned well.

These objects and other objects, aspects and advantages of the present invention will become more apparent from the following detailed description of the embodiments of the present invention when taken in conjunction with the accompanying drawings, in which:

Figure 1 is a cross-sectional view showing one embodiment in accordance with the present invention;

Figure 2 through Figure 7 are cross-sectional views showing one example of a method of manufacturing a printed circuit board of Figure 1 embodiment in the sequence of process, respectively;

Figure 8 is a cross-sectional view showing another embodiment in accordance with the present invention;

Figure 9 and Figure 10 are cross-sectional views showing a part of a method of manufacturing a printed circuit board of Figure 8 embodiment, respectively;

Figure 11 and Figure 12 are equivalent circuit diagrams for explaining effects of the embodiments in accordance with the present invention; and

Figure 13 is a graph for explaining effects of the embodiments in accordance with the present invention, and the abscissa represents frequency and the ordinate represents the intensity of radiation electric field, respectively.

Figure 1 is a cross-sectional view showing one embodiment in accordance with the present invention. A printed circuit board 10 includes a base plate 12 composed of an insulating material, for example, synthetic resin or ceramics. This base plate 12 is constituted as a so-called double-sided board, and on each of the both main surfaces of the base plate 12, electric conductive layer 14 as a first electric conductive layer composed, for example, of copper foil is formed. This electric conductive layer 14 includes a circuit pattern portion for required circuits, that is, a signal electrode portion and a ground electrode portion 14a which are formed by means of etching.

A throughhole 16 is formed in the base plate 12, and a plating layer 18 is formed on the inner wall of this throughhole 16. This plating layer 18 is formed in the case where interconnection between the electric conductive layers 14 on the both surfaces of the base plate 12 is required, and the both ends thereof are connected to the corresponding electric conductive layers 14, respectively. In addition, the plating layer 18 may be unnecessary in the case where the throughhole 16 is used only for inserting parts (not illustrated).

A solder resist layer 20 is formed on each of the both main surfaces of the base plate 12 so as to cover the electric conductive layer 14 but except a part of the ground electrode portion 14a. This solder resist layer 20 is formed in the area whereto solder is not to adhere in the later process of the electric conductive layer 14, and furthermore the same can be also utilized to secure insulation between a copper ink layer 22 as described later and the electric conductive layer 14. Also, the copper ink layer 22 as described later is connected to the ground electrode portion 14a which is not covered by the solder resist layer 20.

On each of the both main surfaces of the base plate 12, the copper ink layer 22 as a second electric conductive layer is formed on the solder resist layer 20 over nearly the whole surface of the base plate 12 so as to cover the electric conductive layer 14, particularly to cover the signal electrode portion thereof. For the copper ink for forming this copper ink layer 22, for example, an ink having composition as described later can be utilized.

To be brief, the copper ink is made by mixing metallic copper powder as a filler, a binder for firmly sticking the metallic copper powder and to other materials. It is needless to say that the particle size of metallic copper powder is selected smaller than the mesh size of a silk screen used in printing this copper ink layer 22. Also, for the binder, a solvent of thermosetting synthetic resin, for example, phenol resin wherein electrolytic carriers are dispersed is used.

The specific resistance of such a copper ink layer 22 after curing is, for example, $10^{-3}$ - $10^{-5}\Omega\cdot$cm. Accordingly, this copper ink layer 22 functions sufficiently as a shield against electromagnetic interference.

On the surface of the base plate 12, a solder resist layer 24 as a second insulating layer is formed so as to cover the copper ink layer 22.

The above-described copper ink layer 22 is effective as a measure for preventing electromagnetic interference. More specifically, the signal electrode portion of the electric conductive layer 14 is disposed close to the copper ink layer 22, and therefore a stray capacity or distributed capacity is formed between the respective signal electrodes of the electric conductive layer 14 and the copper ink layer 20 rather than signal electrodes. Accordingly, spurious electromagnetic energy induced in the- signal electrode of the electric conductive layer 14 flows into the copper ink layer 22 through the formed distributed capacity. On the other hand, the copper ink layer 22 is connected to the ground electrode portion 14a of the electric conductive layer 14 as descried above, and is grounded as to high frequency components. Accordingly, the electromagnetic energy flowing into the copper ink layer 22 through the above-described distributed capacity eventually flows into high-frequency ground. Consequently, no spurious electromagnetic energy is stored in each signal electrode of the electric conductive layer 14. Accordingly, even if an electronic circuitry is constituted using the printed circuit board 10 and a cable or the like is connected thereto, no radiation energy is transferred through this cable.

This is explained more specifically in reference to Fig. 11 and Fig. 12. Fig. 11 is an equivalent circuit diagram of a conventional printed circuit board, and in this equivalent circuit, signal electrodes 2 and 3 connecting elements la and lb and a ground electrode 4 having inductances according to the lengths thereof, respectively, and distributed capacities in accordance with the distance between the electrodes are formed between the signal electrodes 2 and 3 and between the signal electrodes 2 and 3 and the ground electrode 4. Then, if the ground electrode 4 has an inductance component, the ground electrode 4 does not act as an ideal ground for a high-frequency component of the signal, and a potential difference is produced between the both ends of the ground electrode 4 by this inductance, and energy by this potential difference remains on the ground electrode 4. When this remaining energy becomes large, it leaks outside as noise and has an electromagnetic interference with the surrounding electronic components and equipments.

On the other hand, in the printed circuit board of this embodiment, the equivalent circuit thereof is as shown in Fig. 12, and the copper ink layer 22 and thus a ground electrode 4′ covers nearly the whole surfaces of the signal electrodes 2 and 3, and therefore this ground electrode 4′ does not contain an inductance component and no high-frequency potential difference is produced, and therefore there is little chance that energy remains on the ground electrode 4′.

Also, in the conventional printed circuit board, respective distributed capacities differ depending on the distance between the signal electrodes 2 and 3 and the ground electrode 4, and the distributed capacity becomes non-uniform, and the impedance is varied on the path of flow of the signal, and a mismatching of transmission of high frequency wave is produced. Consequently, the spurious electromagnetic energy in the signal

stays on the signal electrodes 2 and 3, and this energy leaks as noise to external electrodes or radiates away.

On the other hand, in the printed circuit board of this embodiment, the first electric conductive layer 14 and the second electric conductive layer 22 are laminated through the insulating layer 20 having nearly a uniform thickness, and therefore the distance between each of the signal electrodes 2 and 3 and the ground electrodes 4′ is nearly uniform, and thereby the distributed capacity between the both is made uniform. Then, the distributed capacity becomes a large value to the extend that the distributed capacity between the signal electrodes 2 and 3 can be neglected. Accordingly, the electromagnetic energy which, conventionally, would have been stored in the signal electrodes 2 and 3 flows into the ground electrode 4′ through that distributed capacity, and therefore no spurious radiation takes place.

In Fig. 13, a line A shows the radiation level when the conventional printed circuit board is used, and a line B shows the radiation level when the printed circuit board of the embodiment in accordance with the present invention is used. As is understood from Fig. 13, in the conventional case, for example, spurious radiation as large as 50.60 dBμV was produced at 67.03 MHz. On the other hand, in accordance with the present invention, the radiation level is nearly of noise component alone, and thereby the regulations of FCC and others can be overcome without any problems at all.

Next, description is made on one example of a method of manufacturing the printed circuit board 10 of Fig. 1 embodiment.

First, as shown in Fig. 2, the base plate 12 is prepared. This base plate 12 is made, for example, of synthetic resin such as epoxy resin or phenol, ceramics or the like with the thickness thereof set at, for example, 1.2 - 1.6 mm. Then, on each of the both main surfaces of the base plate 12, the electric conductive layer 14′ in which a signal electrode pattern in accordance with a circuit required for the first electric conductive layer 14 in the later process is to be formed is formed by copper foil, for example, of about 30 - 70 μm in thickness.

Subsequently, as shown in Fig. 3, the throughhole 16 is formed in the base plate 12 so as to penetrate the electric conductive layers 14′, for example, using a multispindle drilling machine. This throughhole 16 is utilized to interconnect the electric conductive layers 14 of the both main surfaces, and can be also utilized as a mere hole for inserting leads of electronic parts. Then, a grinding treatment of the end faces of the drilled hole is performed, and the base plate 12 is transferred to the next process.

Next, as shown in Fig. 4, the plating layer 18 is formed on the inner wall of the throughhole 16, for example, by electrolytic plating or chemical plating. Accordingly, the electric conductive layers 14′ on the both surfaces of the base plate 12 are connected to each other.

Subsequently, the electric conductive layer 14′ is etched to form the signal electrode portion according to the required circuit including the ground electrode portion 14a as shown in Fig. 5. More specifically, etching resist is first printed in accordance with the pattern of the required signal electrode, and "hole filling" of the throughhole 16 and the like are performed, and thereafter wet etching or dry etching is applied, and thereby the required signal electrode portion and ground electrode portion are formed.

Thereafter, as shown in Fig. 6, the solder resist layer 20 functioning as the first insulating layer is printed. At this time, rust preventing treatment may be applied to prevent oxidation and deterioration of the electric conductive layer 14.

The processes hereto are well known as general manufacturing processes of the conventional printed circuit board.

Next, as shown in Fig. 7, the copper ink layer 22 is formed on the first insulating layer, that is, the solder resist layer 20 over nearly the whole surface so as to cover the electric conductive layer 14. To be detailed, a silk screen (not illustrated) having a printed pattern required as the copper ink layer 22 is disposed on the main surface of the base plate 12 and is positioned, and printing is performed by a predetermined copper ink.

In addition, when a copper ink having a sufficiently small specific resistance is used, the copper ink layer 22 may be formed so as to completely cover the ground electrode portion 14a.

Thereafter, the printed copper ink is cured by heating. Resin mixture used as a binder is of thermosetting type, being cured by condensation reaction by heating. In this curing, the copper ink layer 22 shrinks not only in the direction of the film surface but also in the direction of the thickness. In addition, the results of the experiment conducted by the inventors et al. showed that the strength of adhesion of the copper ink layer 22 after curing to the base plate 12, for example, can withstand 3 kg of tensile load by with a 3ϕ land, being nearly equal to that of the electric conductive layer 14 composed of copper foil.

Finally, as shown in Fig. 1, the solder resist layer 26 as the second insulating layer is formed over the whole area of each of the both surfaces of the base plate 12, for example, by means of coating or printing. Thus, the printed circuit board 10 is manufactured.

For the copper ink used advantageously for the embodiment as shown in Fig. 1 through Fig. 7, the following copper ink is used, which is made by blending 15 - 45 PHR in weight of mixture of resol type phenol resin and p-tert-butyl phenol resin and 0.5 - 7 PHR in weight of unsaturated fatty acid or alkali metallic salt thereof with

100 PHR in weight of metallic copper powder.

More preferably, the mixing ratio in weight of resol type phenol resin and p-tert-butyl phenol resin is selected to be 65:35 - 97:3.

Then, the degree of polymerization of p-tert-butyl phenol resin is preferably not more than 50.

Metallic copper power is preferably of a dendrite shape, and the average particle size is preferably 2 - 20 μm. For the specific example, the electrolytic copper powder "CE 1110A" manufactured by Fukuda Metal Foil & Powder Co., Ltd., and the "MF-D3" manufactured by Mitsui Mining & Smelting Co., Ltd. and etc. are listed.

In the copper ink of this embodiment, a mixture of resol type phenol resin and p-tert-butyl phenol resin acts as a binder, also acting effectively to maintain the electric conductivity for a long time period.

Normal resol type phenol resin can be used for this purpose. The above-described p-tert-butyl phenol resin is obtained by heat-polymerizing p-tert-butyl phenol and formalin under the presence of an alkali catalyst, and the degree of polymerization thereof is preferably not more than 50 for the use. When using the one whose degree of polymerization exceeds 50, formation of the network structure of resol type phenol resin is hindered in thermosetting the obtained copper ink, and contact between metallic copper powder cannot be obtained, resulting in a reduction in electric conductivity.

Also, the combining ratio of the binder composed of the above-described resin mixture is 15 - 45 PHR in weight or preferably 20 - 40 PHR in weight to 100 PHR in weight of metallic copper powder, and when it is less than 15 PHR in weight, the absolute amount of the binder is insufficient, resulting in a poor fluidity of the copper ink to be obtained, and the printablity is reduced and copper powder is easy to be oxidized, incurring a reduction in the electric conductivity of the copper ink layer. When the amount of the binder exceeds 45 PHR in weight, in reverse, the absolute amount of copper powder is insufficient, and the electric conductivity required for forming the electromagnetic interference preventing shield cannot be obtained.

Then, a mixture of 65 - 97 weight percent of resol type phenol resin and 35 - 3 weight percent of p-tert-butyl phenol resin is preferable. When butyl phenol resin exceeds 35 weight percent, the copper ink layer after thermosetting becomes brittle and formation of the network structure of resol type phenol resin is hindered, and contact between copper powder cannot not be obtained, resulting in a reduction in electric conductivity. When it is not more than 3 weight percent, the electric conductivity immediately after thermosetting has no particular problem, but the electric conductivity of the copper ink layer is greatly reduced with time, and this layer can not withstand a long time period of use as a shield for preventing electromagnetic interference.

Furthermore, unsaturated fatty acid or alkali metallic salt thereof acts as a dispersant and as a weak reducing agent to prevent oxidation of metallic copper powder, thereby the same contributes to maintaining the electric conductivity, and is absorbed on the surface of copper powder, accelerates dispersion of copper powder, resulting in a copper ink layer having a good electric conductivity. For examples of preferred unsaturated fatty acid, olein acid and linoleic acid are listed, and for examples of alkali metallic salt, sodium salt and potassium salt are listed. Furthermore, vegetable oil containing not less than 60 weight percent of unsaturated fatty acid, for example, bean oil, sesame oil, olive oil or safflower oil can also be used. The added amount is 0.5 - 7 PHR in weight, preferably 2 - 6 PHR in weight to 100 PHR in weight of metallic copper powder. In the case of less than 0.5 PHR in weight dispersion of metallic copper powder in the binder becomes poor, and the electric conductivity is reduced, and in the case of exceeding 7 PHR in weight, not only an improvement in dispersion corresponding to the added amount can not be obtained, but also the electric conductivity of the copper ink layer to be obtained is reduced.

Thus, a copper paste or copper ink used for this embodiment is obtained by mixing and kneading metallic copper powder, a binder composed of a specific resin mixture and a dispersant composed of unsaturated fatty acid or alkali metallic salt thereof. In addition, a reducing agent conventionally used may be blended as desired.

Here, further detailed description is made on the above-mentioned copper ink in comparison with comparative examples.

Embodied samples 1 - 12

Electrolytic copper powder having an average particle size of 3μm, for example, the "CE1110A" manufactured by ) Fukuda Metal Foil & Powder Co., Ltd., resol type phenol resin, for example, the "PL2211", 58 percent in resin concentration, manufactured by Gunei Chemical Industry Co., Ltd., p-tert-butyl phenol resin and unsaturated fatty acid or alkali metallic salt thereof were mixed and kneaded with 5 the composition as shown in Table 1 to prepare each embodied samples. In addition, p-tert-butyl phenol resin (I) in Table 1 is 50 or less in the degree of polymerization.

The obtained copper ink samples 1 - 12 were screen-printed in a band shape of 2mm in width and 35 - 45μm in thickness between electrodes (intervals of 60 mm) on a glass-epoxy resin base plate, and underwent thermosetting of 150°C x 60 min to form conductors (copper ink layers), and the volume resistivity was measured using a digital multimeter. Furthermore, in order to make sure whether or not an electric conductivity capable of withstanding a long time period of use is obtainable, the samples were subjected to two kinds of oxidation acceleration tests, namely, humidity cabinet test; 40°C x 95% RH x 500 hours and heating test; 100° x 500 hours, and the changing rate of volume resistivity (hereinafter referred to as "resistance changing rate") was measured. Table 1 shows the results of the measurement.

In addition, calculations of the volume resistivity and the resistance changing rate were performed according to the following equations (1) and (2).

$$\text{Volume resistivity } (\Omega\cdot\text{cm}) = R \times t \times W/L \quad (1)$$

where,

R: Resistance value between electrodes (Ω)
t: Thickness of coated film (cm)
W: Width of coated film (cm)
L: Distance between electrodes.

$$\text{Resistance changing rate } (\%) = 100X(R_{500} - R_0)/R_0 \quad (2)$$

where,

$R_0$: Resistance value before test (Ω)
$R_{500}$: Resistance value after humidity cabinet test or heating test for 500 hours.

Furthermore, the printability of each sample was studied according to the following judging standard.

○ : Having a good printability
Δ: Capable of printing somehow
X: Incapable of printing

The results of the study are shown in Table 1.

Comparative samples 1 - 8

Mixtures having compositions as shown in Table 2 were prepared, and conductors were formed on the base plates likewise the embodied samples, and thereafter the volume resistivity, the resistance changing rate after humidity cabinet test and the resistance changing rate after heating test were measured and further the printability was also studied. Table 2 shows the results of the measurement and the study. In addition, p-tert-butyl phenol resin (II) in Table 2 contains 30 weight percent of p-tert-butyl phenol resin exceeding 50 in degree of polymerization.

Comparative sample 9

A copper ink composed of 100 PHR in weight of copper powder, 25 PHR in weight of resol type phenol resin, 4 PHR in weight of olein acid and 0.6 PHR in weight of organic titanium compound was prepared, and the volume resistivity, the resistance changing rate after humidity cabinet test, the resistance changing rate after heating test and the printability were studied likewise the embodied samples. The results of the study are shown in Table 2. In addition, tetra (2,2 - diallyloxymethyl-1 butyl) bis [di(tridecil)] hosfitetinate was used as an organic titanium compound.

Comparative sample 10

A copper ink composed of 100 PHR in weight of copper powder, 25 PHR in weight of resol type phenol resin and 1.25 PHR in weight of anthracene as a reducing agent was prepared, and the volume resistivity, the resistance changing rate after humidity cabinet test, the resistance changing rate after heating test and the printability were studied likewise the embodied samples. The results of the study are shown in Table 2.

As is apparent in the comparison of the results in Table 1 and Table 2, by blending p-tert-butyl phenol resin as is the case with the copper inks having the above-described compositions, a conductor, that is, an electric conductive layer capable of withstanding a long time period of use without spoiling the printability is obtainable, and the effect thereof is remarkable particularly in the case of 50 or less in degree of polymerization of p-tert-butyl phenol resin. Furthermore, it is found that the effect is excellent within a range of 65:35 - 97:3 of the mixing ratio of resol type phenol resin and p-tert-butyl phenol resin. It is also obvious that when the amounts of binder and unsaturated fatty acid to metallic copper powder are within ranges as shown in Table, 1, a particularly excellent electric conductivity and a long time period of stability of electric conductivity are obtainable.

On the other hand, the copper ink of the comparative sample 9 made by blending an organic titanium compound, as is obvious from the results of the humidity cabinet test and the heating test, cannot withstand sufficiently a long time period of use, and the copper ink of the comparative sample 10 made by blending anthracene is inferior in any of the initial volume resistivity, the resistance changing rate after humidity cabinet test and the resistance changing rate after heating test.

In another embodiment, in order to form the copper ink layer 22, a copper ink is used which is made by blending 15 - 50 PHR in weight of resin mixture (resin mixture composed of 20 - 60 weight percent of melamine resin and 80 - 40 weight percent of polyol and polyester resin and/or alkyd resin) and 1 - 8 PHR in weight of saturated fatty acid or unsaturated fatty acid or metallic salt thereof with 100 PHR in weight of metallic copper powder.

To be more preferable, the blending ratio of polyester resin and/or alkyd resin and polyol is 95 - 50: 5 - 50.

Metallic copper powder may have any shape of strip, branch, sphere and unfixed shape, and the particle size thereof is preferably less than 100μm, and particularly 1 - 30μm. Metallic copper powder whose particle size is less than 1μm is easily oxidized, and the electric conductivity of a coated film to be obtained is reduced, and therefore it is not preferable. Then, the blended amount of metallic copper powder is always used as 100 PHR in weight.

The binder, that is, melamine resin in the resin mixture is alkylated melamine resin, and at least one kind is used which is selected from among methylated melamine resin, butylated melamine and the like. Melamine resin well binds metallic copper powder and other components. The amount of melamine resin in the resin mixture blended with polyol and polyester resin and/or alkyd resin which are used as other binders is within a range of 20 - 60 weight percent, and preferably 30 - 50 weight percent. When the blended amount of melamine resin is less than 20 weight percent, metallic copper powder cannot be bound enough, and the network structure of melamine resin becomes unstable, and the electric conductivity of the copper ink layer is remarkably reduced, and therefore this is not preferable. In reverse, the blended amount exceeding 60 weigh percent is not preferable because the electric conductivity of the copper ink layer is remarkably reduced.

Polyol in the resin mixture is polyester polyol, and makes cross linking with melamine resin.

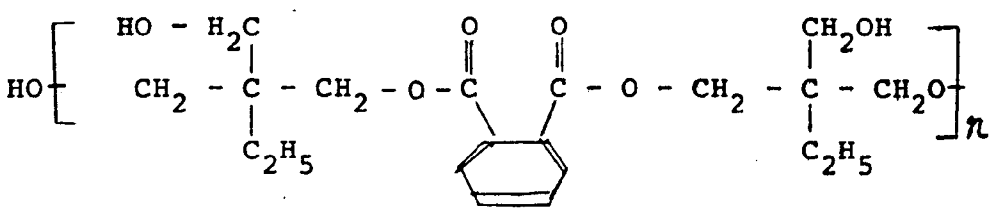

A total of hydroxyl group value and acid value of polyol to be used is 100mg/g or more, and preferably 130mg/g or more. Use of polyol wherein a total of hydroxyl group value and acid value is less than 100mg/g causes the copper ink layer to lose electric conductivity, therefore being not preferable.

The amount of polyol in the resin mixture blended with polyester resin and/or alkyd resin is within a range of 50 - 95 weight percent, and preferably 60 - 90 weight percent. When the blended amount of polyol is less than 50 weight percent, the electric conductivity of the copper ink layer is not good, and in reverse, when exceeding 95 weight percent, a good adhesion of the copper ink layer to the base plate cannot be obtained.

Polyester resin and/or alkyd resin, in the resin mixture makes a relaxing or suppressing action in the condensation reaction of melamine resin and polyol, and improves the property of the copper ink layer as a vehicle,

The average molecular weight of polyester resin and/or alkyd resin to be used is preferably 5000 or more, and more preferably 8000 or more. When the average molecular weight is less than 5000, the adhesion of the copper ink layer to the base plate is remarkably reduced, and therefore this is not preferable.

The amont of polyester resin and/or alkyd resin blended with polyol is within a range of 5 - 50 weight percent, and preferably 10 - 40 weight percent. When the blended amount of polyester resin and/or alkyd resin is less than 5 weight percent, the adhesion of the copper ink layer is not good, and in reverse, when exceeding 50 weight percent, electric conductivity of the copper ink layer is remarkably reduced, and therefore this is not preferable.

The amount of polyol and polyester resing and/or alkyd resin in the resin mixture blended with melamine resin is within a range of 80 - 40 weight percent, and preferably 70 - 50 weight percent.

The blended amount of the binder, that is, the resin mixture (resin mixture composed of 20 - 60 weight percent of melamine resin and 80 - 40 weight percent of polyol and polyester resin and/or alkyd resin) is within a range of 15 - 50 PHR in weight and preferably 20 - 40 PHR in weight to 100 PHR in weight of metallic copper powder.

Saturated fatty acid or unsaturated fatty acid or metallic salt thereof acts as a dispersant dispersing metallic copper powder in the resin mixture, and for saturated fatty acid, palmitic acid, stearic acid, arachic acid

or the like having a carbon number of 16 - 20 is used, and for unsaturated fatty acid, zoomaric acid, olein acid, linolenic acid or the like having a carbon number of 16 - 18 is used, and metallic salt thereof is salt with sodium, potassium, copper, zinc, aluminum or the like.

The blended amount of saturated fatty acid or unsaturated fatty acid or metallic salt thereof is within a range of 1 - 8 PHR in weight and preferably 2 - 6 PHR in weight to 100PHR in weight of metallic copper powder. When the blended amount of dispersant is less than 1 PHR in weight, much time is required for kneading to microdisperse metallic copper powder in the resin mixture, and in reverse, when exceeding 8 PHR in weight, the electric conductivity of the copper ink layer is reduced, and therefore this is not preferable.

Furthermore, to adjust the coefficient of viscosity, a normal organic solvent can be used properly, For example, ethylene glycol meno ethyl ether acetate (ethyl cellosolve acetate) and ethylene glycol meno n-butyl ether acetate (n-butyl cellosolve acetate) are well known solvents.

Here, further detailed description is made on the copper ink having this composition in comparison with the comparative examples.

Branched-shaped metallic copper powder having a particle size of 5 - 10μm, stearic acid as a dispersant, olein acid and potassium oleinate, melamine resin of resin mixture as a binder, polyester polyol, polyester resin and alkyd resin were blended by the ratios (PHR in weight) as shown in Table 3. Some amount of n-butyl cellosolve acetate was added thereto as a solvent, and they were kneaded by a three axle roll for 20 minutes to prepare the embodied samples 1 - 7. Five electric conductive lines of 2mm in width, 30 ± 5μm in thickness and 100mm in length were printed on a glass-epoxy resin base plate by the screen printing method using these samples, and the copper ink was cured by heating to 130 - 180°C for 10 - 60 minutes, and the volume resistivity, that is, the electric conductivity of the cured copper ink layer was measured.

On the other hand, the copper-foil surface of a printed wire board underwent a cleaning treatment, and thereafter the copper ink of 50 x 50 $mm^2$ was printed on that copper-foil surface by the screen printing method, and the copper ink was cured by heating likewise the embodied samples, and thereafter parallel lines orthogonal to one another were cut in with intervals of 1mm kept on the copper ink layer in accordance with the cross cut test, JIS (Japan Industrial Standards), test item K5400 (1979) and checker-shaped cuts were made so that 100 squares were formed in 1$cm^2$, and at this time, the state that the copper ink layer is peeled off the copper-foil surface was visually observed. Table 3 shows the results of the study on these characteristics.

As is understood from Table 3, the embodied samples 1 - 7 excell in the characteristics such as electric conductivity of the copper ink layer, that is, the volume resistivity and the adhesion of the copper ink layer to the copper-foil surface.

However, as to the comparative samples, the comparative sample 1 contains large amounts of butylate melamine resin, polyester polyol and polyester resin, and therefore the electric conductivity of the copper ink layer is remarkably reduced and the adhesion of the copper ink layer is not preferable. The comparative example 2 has no electric conductivity at all because of a low hydroxyl group value of polyester polyol to be used. For the comparative sample 3, the adhesion of the copper ink layer is not preferable because the average molecular weight of alkyd resin to be used is less than 5000. The comparative sample 4 contains a large amount of metallic copper powder and not contains polyester resin and/or alkyd resin, and therefore the electric conductivity of the copper ink layer is reduce and the adhesion of the copper ink layer is not preferable.

Fig. 8 is a cross-sectional view showing another embodiment in accordance with the present invention. In the previous embodiment, the copper ink layer 22 is effective for preventing electromagnetic interference. On the other hand, in this embodiment, the copper ink layer 22′ and the solder layer 26 prevent electromagnetic interference.

To be detailed, the copper ink layer 22′ is formed using the copper ink likewise also in this embodiment, but when the binder is cured, a solderable layer is formed in the vicinity of the surface of this copper ink layer 22′. Then, the solder layer 26 is formed on this copper ink layer 22′ (solderable layer), the plating layer 18 on the inner wall of the throughhole 16 and the electric conductive layer 14, for example, by means of solder dipping. This solder layer 26 is formed on nearly the whole area of the main surface of the base plate 12 likewise the solderable layer (copper ink layer)22′. At this time, the solder resist layer 20 is removed on a part of the ground electrode portion 14a, and therefore eventually the solder layer 26 is connected to that ground electrode portion 14a.

The solder layer 26 serves to reduce the specific resistance of the copper ink layer 22′ (improves the electric conductivity) and to increase the mechanical strength thereof. Assuming that the specific resistance of only the copper ink layer 22′ after cured is, for example, about $10^{-4}\Omega\cdot cm$, as a whole, the specific resistance becomes, for example, about $10^{-5}\Omega\cdot cm$ after the solder layer 26 has been formed. Accordingly, this copper ink layer 22′, that is, the solder layer 26 can function as a shield against electromagnetic interference.

In addition, at this time, the solder layer 26 has only to be formed so as to cover at least the copper ink layer 22′, and is not necessarily formed on the signal electrode portion formed by copper foil, that is, the electric

conductive layer 14 or the plating layer 18.

On the surface of the base plate 12, the solder resist layer 24 as the second insulating layer is further formed so as to cover the solder resist layer 20 and the solder layer 26.

Next, description is made on one example of the method of manufacturing the printed circuit board 10 of Fig. 8 embodiment in reference to Fig, 9 and Fig. 10.

The processes as shown in Fig. 2 through Fig. 6 are also employed for this embodiment. Then, after the process of Fig. 6, as shown in Fig. 9, the copper ink layer 22′ is formed on nearly the whole of the first insulating layer, that is, the solder resist layer 20 and/or the electric conductive layer 14. To be detailed, a silk screen (not illustrated) having a printed pattern of a shape required as a shield against electromagnetic interference is disposed, positioned and printed by a predetermined copper ink on the main surface of the base plate 12.

Thereafter, the printed copper ink is heated to be cured. When the copper ink is cured, a solderable layer is formed in the vicinity of the surface thereof. This means that the surface of the copper ink layer 22′ becomes solderable.

Thereafter, as shown in Fig. 10, the solder layer 26 is formed on all portions whereto solder actually adheres so as to cover at least the copper ink layer 22′. To be detailed, in this process of Fig. 10, solder is made to adhere on the main surface of the base plate 12 by means of solder leveller, reflow soldering or solder dipping.

As described above, this solder layer 26 mechanically reinforces the copper ink layer 22′ and improves the electric conductivity as an electromagnetic shield.

Finally, as shown in Fig. 8, the solder resist layer 24 as the second insulating layer is formed on the whole area of each of the both main surfaces of the base plate 12, for example, by means of coating or printing. Thus, the printed circuit board 10 is manufactured.

In addition, in the above-described embodiment, to form the solderable layer, a copper ink having a relatively small specific resistance is used. However, this solderable layer may be formed by an electric conductive ink having a smaller electric conductivity, and may be an insulating ink having a specific resistance of, for example, about $10^6$ - $10^8\Omega$·cm.

In summary, a solderable layer has only to be formed thereof. Because the solder layer 26 formed in the process thereafter has a sufficient electric conductivity and can virtually function enough as an electromagnetic shield. In this case, it will be necessary that the copper ink 22′ is formed so as to completely cover the ground electrode portion. Because the solder layer 26 to be formed layer is insulated from the electric conductive layer 14′ by the copper ink layer 22′.

In the case where the solderble layer having insulating property is formed, it will be unnecessary to particularly form the solder resist layer 20 as the first insulating layer. Because insulation between the solder layer 26 and the electric conductive layer 14 can be secured by the solderable layer itself.

In the embodiment as shown in Fig. 8 through Fig. 10, a copper ink having the following composition is utilized. To be described specifically, a copper ink is used which is made by blending 1 - 8 PHR in weight of saturated fatty acid or unsaturated fatty acid or metallic salt thereof as a dispersant, 1 - 50 PHR in weight of metallic chelating agent and 0.1 - 2.5 PHR in weight of soldering accelerating agent with a total of 100 PHR in weight of 85 - 95% weight percent of metallic copper powder and 15 - 5 weight percent of resin mixture as a binder. For the resin mixture, a resin mixture composed of 2 - 30 weight percent of metal surface activating agent and the rest of thermosetting resin is used.

The metallic copper powder may be of any shape of strip, branch, saphere or unfixed shape, and the particle size thereof is preferably not more than 100μm, and particularly 1 - 30 μm is preferable. Powder having a particle size of less than 1μm is easily oxidized, and the electric conductivity of the copper ink layer to be obtained is reduced and the solderability becomes poor.

The amount of metallic copper powder blended with the binder, that is, the resin mixture is within a range of 85 - 95 weight percent, and preferably 87 - 93 weight percent. When the blended amount is less than 85 weight percent, the electric conductivity of the copper ink layer is reduced and the solderability becomes brittle, the electric conductivity is reduced, and the screen-printability also becomes poor.

For the metal surface activating agent in the resin mixture, at least one kind is selected from among denatured rosin such as active rosin,partially hydrofined rosin, fully hydrofined rosin, esterifined rosin, maleic, rosin, disproportional rosin and polymerized rosin. Active rosin or maleic rosin is preferable.

The blended amount of metal surface activating resin in the resin mixture is within a range of 2 - 30 weight percent, and preferably 5 - 10 weight percent. Even when the blended amount of metal surface activating resin is less than 2 weight percent, if the metallic chelating agent and the soldering accelerating agent as described later are blended by proper amounts, soldering can be made directly onto the formed copper ink layer, and by adding them within such a preferable range of blending, the soldered surface can be made smoother and metal-glossier. In reverse, when exceeding 30 weight percent, the electric conductivity of the copper ink layer is reduced and the effect of the increased amount on the solderablity is not recognized, and therefore this is not preferable.

Thermosetting resin in the resin mixture serves to bind metallic copper powder and other components, and has only to be a low-molecular substance being liquid at normal temperature and become a higher- molecular substance by thermosetting, and for example, phenol, acryl, expoxy, polyester or xylene family resin is used, but the use is not limited to these resins. Among all, resol type phenol resin is used as preferable. The blended amount of thermosetting resin in the mixture is within a range of 98 - 70 weight percent.

The amount of the above-described binder, that is, resin mixture, blended with metallic copper powder is within a range of 15 - 5 weight percent, taking a total blended amount of metallic copper powder and resin mixture as 100 PHR in weight. When the blended amount of resin mixture is less than 5 weight percent, metallic copper powder is not bound sufficiently, and the copper ink layer to be obtained becomes brittle, the electric conductivity thereof is reduced and the screen-printability becomes poor, and therefore this is not preferable. In reverse, when exceeding 15 weight percent, the solderability is not preferable.

Saturated fatty acid or unsaturated fatty acid or metallic salt thereof acts as a dispersant. For saturated fatty acid, palmitic acid, stearic acid, arachic acid and the like having a carbon number of 16 - 20 can be utilized, and for unsaturated fatty acid, zoomaric acid, olein acid, linolenic acid and the like having a carbon number of 16 - 18 can be utilized, and metallic salt thereof is salt with metal such as potassium, copper or aluminum. In the blend of metallic copper powder and resin mixture, the use such a dispersant accelerates microdispersion of metallic copper powder in the resin mixture, and the copper ink layer having a good electric conductivity is preferably formed.

The blended amount of saturated fatty acid or unsaturated fatty acid or metallic salt thereof is within a range of 1 - 8 PHR in weight and preferably 2 - 6 PHR in weight to a total of 100 PHR in weight of metallic copper powder and resin mixture. When the blended amount of dispersant is less than 1 PHR in weight, much time is required for kneading in microdispersing metallic copper powder in the resin mixture, and in reverse, when exceeding 8 PHR in weight, the electric conductivity of the copper ink layer is reduced and the adhesion of the copper ink layer to the base plate is reduced, and therefore this is not preferable.

For the metallic chelating agent, at least one kind is used which is selected from among fatty amines such as monoethanolamine, diethanolamine, triethanolamine, ethylene diamine, triethylene diamine and triethylene tetramine. The metallic chelating agent to be added prevents oxidation of metallic copper powder, contributing to maintaining the electric conductivity, and more improves the solderability by synergism with the metal surface activating resin. For example, by a blend of metallic copper power, thermosetting resin and metal surface activating resin, good soldering cannot be made on the copper ink surface, but by blending the metallic chelating agent, good soldering can be made, and therefore the role thereof for synergism is great.

The blended amount of metallic chelating agent is within a range of 1 - 50 PHR in weight and preferably 5 - 30 PHR in weight to a total amount of 100 PHR in weight of metallic copper powder and resin mixture. When the blended amount of metallic chelating agent is less than 5 PHR in weight, the electric conductivity is reduced, and the solderability is not preferable. In reverse, when exceeding 50 PHR in weight, the viscosity of the copper ink itself is excessively reduced and the solderability is spoiled, and therefore this is not preferable.

For the soldering accelerating agent, at least one kind is used which is selected from among oxidicarboxylic acid, aminodicarboxylic acid and metallic salts thereof, for example, tartaric acid, maleic acid, glutamic acid, asparatic acid and metallic salts thereof. The soldering accelerating agent further improves the solderability by synergism with the metallic chelating agent. This means that by blending the metal surface activating resin, the metallic chelating agent and the soldering accelerating agent, a greater synergism is exerted and the soldered surface of the copper ink layer can be made smoother and metal-glossier.

The blended amount of soldering accelerating agent is within a range of 0.1 - 2.5 PHR in weight and preferably 0.5 2.5 PHR in weight to a total of 100 PHR in weight of metallic copper powder and resin mixture. Even when the blended amount of soldering accelerating agent is less than 0.1 PHR in weight, if the metal surface activating agent and the metallic chelating agent are blended by proper amounts, soldering can be made directly onto the copper ink layer, but by setting the blended amount within such a preferable range, the soldered surface can be made smoother and metal-glossier. In reverse, when exceeding 2.5 PHR in weight, the electric conductivity of the copper ink layer is reduced and the solderability is not preferable.

Also, to adjust the coefficient of viscosity, normal organic solvents can be properly used, For example, they are well known solvents such as diethylene glycol mono-n-butyl ether (n-butyl-carbitol), diethylene glycol-mono-butyl ether (n-butyl-carbitol acetate), ethylene glycol mono-n-butyl ether (n-butyl cellosolve), methyl isobutyl ketone, toluene, and xylene.

Here, further detailed description is made on the copper ink having this composition in comparison with the comparative examples.

Branch-shaped metallic copper powder having particle sizes of 5 - 10 μm, a resin mixture (resin mixture

consisting of 10 weight percent of maleic rosin and 90 weight percent of resol type phenol resin), potassium oleinate, oleinic acid, triethanolamine and glutamic acid were blended by the ratios ( PHR in weight) as shown in Table 5, and some amount of n-butyl-carbitol was added as a solvent, and they were kneaded for 20 minutes by a three axle roll to prepare an embodied sample. A S-shaped pattern of 0.4mm in width, 30 ± 5μm in thickness and 520mm in length was formed on a glass-epoxy resin base plate by the screen printing method using this sample, and was heated to 180°C for 20 - 60 minutes to cure the copper ink.

Subsequently, in order to apply soldering to the formed copper ink layer, the base plate went through the solder leveller machine to be used in the practical process, and was dipped in a flux bath for 4 seconds, subsequently dipped in a melted solder bath of 250°C (Pb/Sn = 40/60) for 5 seconds and lifted up, simultaneously blown by hot air of an atmospheric pressure of 2-6 and 220-230°C, and cleaned, and thereafter soldering was applied to the whole surface of the copper ink layer.

Table 5 shows the results of study on various characteristics of the copper ink layer obtained in the above-described process. In addition, in Table 5 and Table 6, polyester polyol (I) is of 280 - 300mg/g in hydroxyl group value, not more than 4mg/g in acid value and 1200 in average molecular weight, polyester polyol (II) is of 160 - 180 in hydroxyl group value, not more than 2mg/g in acid value, and 2500 in average molecular weight, polyester polyol (III) is of 40 - 50mg/g in hydroxyl group value, not more than 2mg/g in acid value and 4100 in average molecular value, polyester resin is of 4 - 8 mg/g in hydroxyl group value not more than 5mg/g in acid value and 18000 in average molecular weight, alkyd resin (I) is of 60mg/g in hydroxyl group value, not more than 3mg/g in acid value and 9800 in average molecular weight, and alkyd resin (II) is of 120mg/g in hydroxyl group value, not more than 5mg/g in acid value and 2200 in average molecular weight.

In Table 5 and Table 6, the solderability was evaluated in accordance with the following standard. In the observation on the soldered state on the copper ink layer by means of a low-magnification physical microscope, evaluation was made by the following standards.

◎: Solder whose surface is smooth and metal-glossy adheres to the whole area.
○ : Solder has an uneven surface but adheres to the whole area.
Δ : The copper ink layer is partly exposed.
X: Solder adheres only partly.

The resistance changing rate in the humidity cabinet test refers to the resistance changing rate to the initial resistance obtained after the soldered copper ink layer has been left in an atmosphere of 55°C and 95% RH for 1000 hours.

The resistance changing rate in the heating test refers to the resistance changing rate to the initial resistance obtained after the soldered copper ink layer has been heated at 80°C for 1000 hours.

The film thickness of the solder layer soldered on the copper ink layer of the embodied samples in Table 5 is 10μm in average. As is understood from theses results, the embodied samples 1 - 8 have nice characteristic of the volume resistivity of the copper ink layer, that is, electric conductivity, adhesion of the copper ink layer, solderability onto the copper ink layer, printability of the copper ink and the like because the specific materials to be used for the copper ink are suitably blended.

Particularly, soldering can be made directly on the obtained copper ink layer using a normal organic acid family flux agent, and therefore the electric conductivity thereof can be improved from the order of $10^{-4}\Omega\cdot cm$ to the order of $10^{-5}\ \Omega\cdot cm$. Also, the electric conductivity of the copper ink layer whereon the solder layer is formed excels in heat resistance and moisture resistance and the resistance changing rate is small, and therefore it is understood that this can be used also in an atmosphere of high temperature and high humidity.

Next, as to the comparative samples as shown in Table 6, the comparative sample 1 contains a large amount of metallic copper powder and a small amount of thermosetting resin, and therefore metallic copper powder is not bound sufficiently, and the copper ink layer to be obtained is brittle and difficult to undergo the screen printing, and therefore this sample is not preferable.

The comparative sample 2 contains a small amount of metallic copper powder, and therefore solder adheres only partly onto the copper ink layer in soldering, so that this sample is not preferable. The comparative sample 3 is not added metallic salt of unsaturated fatty acid, and therefore the solderability is slightly reduced, and the resistance changing rates in the heat resisting characteristics and the moisture resisting characteristics are increased. The comparative sample 4 has a large amount of metallic salt of unsaturated fatty acid, and thereby the adhesion of the copper ink layer to the base plate is poor, and therefore this sample is not preferable. The comparative sample 5 is not added the metallic chelating agent, and thereby the electric conductivity of the copper ink layer and the solderability thereto are reduced, and the resistance changing rates in the heat resisting characteristics and the moisture resisting characteristics are increased, and therefore this sample is not preferable. The comparative sample 6 contains a large amount of metallic chelating agent, and therefore the coefficient of viscosity of the copper ink itself is excessively reduced, resulting in difficulty in printing, so that this sample is not preferable.

The comparative sample 7 is not added the soldering accelerating agent, but suitable amounts of metal surface activating resin and metallic chelating agent are blended, and therefore the soldercbility is reduced only slightly. The comparative sample 8 contains a large amount of soldering accelerating agent, and therefore the electric conductivity of the copper ink layer is reduced and the solderability is reduced, so that this sample is not preferable.

In addition, also in any of the above-described embodiment, the copper ink layer 22 (22′) or the solder layer 26 as a shield against electromagnetic interference was formed on each of the both main surfaces of the base plate 12. However, the results of experiment conducted by the inventors et al. show that this layer may be formed on only one of the main surfaces of the base plate 12.

Also, in the case where the copper ink layer 22 (22′) or the solder layer 26 as an electromagnetic shield is formed on each of the both main surfaces of the base plate 12, it is also possible that the ground electrode portion 14a is formed on only one of the main surfaces, and throughholes at several places are connected to ground, and the copper ink layer 22 or the solder layer 26 on the other main surface is connected to those throughholes.

Although the present invention has been described and illustrated in detail, it is clearly understood that the same is by way of illustration and example only and is not to be taken by way of limitation, the scope of the present invention being limited only by the terms of the appended claims.

TABLE 1

| embodied samples | COMPOSITION (PHR in weight) | | | | | | volume resistivity (Ω·cm) | resistance changing rate (%) by hummidity cabinet test | resistance changing rate (%) by heating test | printability |
|---|---|---|---|---|---|---|---|---|---|---|
| | | binder | | | dispersant | | | | | |
| | metallic copper powder | resol type phenol resin | p-tert-butyl phenol resin (I) | resol type phenol resin / p-tert-butyl phenol resin | olein acid | linoleic acid sodium | | | | |
| 1 | 100 | 14.5 | 0.5 | 97/3 | 0.5 | - | $5.4 \times 10^{-4}$ | 47 | 18 | o |
| 2 | 100 | 12 | 3 | 80/20 | 0.5 | - | $5.7 \times 10^{-4}$ | 42 | 16 | o |
| 3 | 100 | 10 | 5 | 67/33 | - | 0.5 | $5.5 \times 10^{-4}$ | 43 | 15 | o |
| 4 | 100 | 19 | 1 | 95/5 | 3 | - | $1.9 \times 10^{-4}$ | 34 | 15 | o |
| 5 | 100 | 17 | 3 | 85/15 | - | 3 | $2.2 \times 10^{-4}$ | 32 | 14 | o |
| 6 | 100 | 13 | 7 | 65/35 | 3 | - | $2.3 \times 10^{-4}$ | 36 | 15 | o |
| 7 | 100 | 29 | 1 | 97/3 | 5 | - | $1.3 \times 10^{-4}$ | 33 | 13 | o |
| 8 | 100 | 24 | 6 | 80/20 | 5 | - | $1.4 \times 10^{-4}$ | 33 | 14 | o |
| 9 | 100 | 20 | 10 | 67/33 | 5 | - | $1.3 \times 10^{-4}$ | 31 | 14 | o |
| 10 | 100 | 35 | 5 | 97/3 | 7 | - | $2.7 \times 10^{-4}$ | 36 | 13 | o |
| 11 | 100 | 38 | 7 | 84/16 | 7 | - | $2.7 \times 10^{-4}$ | 34 | 14 | o |
| 12 | 100 | 30 | 15 | 67/33 | - | 7 | $2.8 \times 10^{-4}$ | 37 | 13 | o |

TABLE 2

| comperative samples | COMPOSITION (PHR in weight) | | | | | | | volume resistivity ($\Omega \cdot cm$) | resistance changing rate (%) by hummidity cabinet test | resistance changing rate (%) by heating test | printability |
|---|---|---|---|---|---|---|---|---|---|---|---|
| | metallic copper powder | binder | | | | disper-sant | other materials | | | | |
| | | resol type phenol resin | p-tert-butyl phenol resin (I) | p-tert-butyl phenol resin (II) | resol type phenol resin / p-tert-butyl phenol resin | olein acid | | | | | |
| 1 | 100 | 15 | - | - | 100/0 | 0.5 | - | $4.9 \times 10^{-4}$ | >100 | > 500 | △ |
| 2 | 100 | 30 | - | - | 100/0 | 5 | - | $1.4 \times 10^{-4}$ | 154 | 62 | o |
| 3 | 100 | 24 | - | 6 | 80/20 | 5 | - | $9.7 \times 10^{-3}$ | >1000 | > 500 | o |
| 4 | 100 | 35 | 15 | - | 70/30 | 5 | - | $1.2 \times 10^{-3}$ | >1000 | > 500 | o |
| 5 | 100 | 20 | 20 | - | 50/50 | 4 | - | $3.3 \times 10^{-4}$ | 411 | 195 | o |
| 6 | 100 | 17 | 3 | - | 85/15 | 0.1 | - | $5.8 \times 10^{-3}$ | >1000 | > 500 | o |
| 7 | 100 | 17 | 3 | - | 85/15 | 8 | - | $4.6 \times 10^{-4}$ | 376 | 158 | o |
| 8 | 100 | 10 | 3 | - | 100/13 | 5 | - | $1.5 \times 10^{-2}$ | >1000 | > 500 | x |
| 9 | 100 | 25 | - | - | 100/0 | 4 | organic titanium compound (0.6) | $3.5 \times 10^{-4}$ | 150 | 350 | o |
| 10 | 100 | 25 | - | - | 100/0 | | anthracene (1.25) | $1 \times 10^{-3}$ | 400 | 51 | o |

TABLE 3

| embodied samples | COMPOSITION (PHR in weight) | | | | | | | | | | | | | | volume resis-tivity (Ω·cm) | adhesion |
|---|---|---|---|---|---|---|---|---|---|---|---|---|---|---|---|---|
| | metallic copper powder | binder | | | | | | | | dispersant | | | | | | |
| | | methlated melamine resin | butylated melamine resin | polyester polyol (I) | polyester polyol (II) | polyester polyol (III) | poly-ester resin | alkyd resin (I) | alkyd resin (II) | stearic acid | olein acid | olein acid potassium | | | | |
| 1 | 100 | - | 8 | 16 | - | - | 1 | - | - | - | - | 4 | | | 8 $\times 10^{-4}$ | 100/100 |
| 2 | 100 | - | 8 | 13 | - | - | 5 | - | - | - | - | 4 | | | 1 $\times 10^{-4}$ | 100/100 |
| 3 | 100 | - | 8 | 9 | - | - | - | 9 | - | 3 | - | - | | | 3 $\times 10^{-4}$ | 100/100 |
| 4 | 100 | 8 | - | 9 | - | - | 9 | - | - | - | 5 | - | | | 4 $\times 10^{-4}$ | 100/100 |
| 5 | 100 | - | 3 | 11 | - | - | 1 | - | - | - | - | 1 | | | 6 $\times 10^{-4}$ | 100/100 |
| 6 | 100 | - | 30 | 10 | - | - | 10 | - | - | - | - | 8 | | | 6 $\times 10^{-4}$ | 100/100 |
| 7 | 100 | - | 8 | - | 13 | - | - | 5 | - | - | - | 4 | | | 1 $\times 10^{-4}$ | 100/100 |

TABLE 4

| compera-tive samples | COMPOSITION (PHR in weight) | | | | | | | | | | | | volume resis-tivity (Ω·cm) | adhesion |
|---|---|---|---|---|---|---|---|---|---|---|---|---|---|---|
| | metallic copper powder | binder | | | | | | | | dispersant | | | | |
| | | methlated melamine resin | butylated melamine resin | polyester polyol (I) | polyester polyol (II) | polyester polyol (III) | poly-ester resin | alkyd resin (I) | alkyd resin (II) | stearic acid | olein acid | olein acid potassium | | |
| 1 | 100 | - | 40 | 20 | - | - | 10 | - | - | - | - | 4 | 10 | 50/100 |
| 2 | 100 | - | 8 | - | - | 13 | 5 | - | - | - | - | 4 | ∞ | 100/100 |
| 3 | 100 | - | 8 | 13 | - | - | - | - | 5 | - | - | 4 | 1 x$10^{-3}$ | 30/100 |
| 4 | 100 | - | 3 | 8 | - | - | - | - | - | - | - | 4 | 10 | 80/100 |

TABLE 5

| embodied samples | COMPOSITION (PHR in weight) | | | | | | volume resis-tivity (Ω·cm) | resis-tance changing rate (%) by hummidity cabinet test | resis-tance changing rate (%) by heating test | adhe-sion | solder-ability | print-ability |
|---|---|---|---|---|---|---|---|---|---|---|---|---|
| | metallic copper powder weight % | binder (resin mix-ture) weight % | dispersant | | metallic chelat-ing agent | soldering accelerat-ing agent | | | | | | |
| | | | olein acid potassium | olein acid | triethanol amine | glutamic acid | | | | | | |
| 1 | 93 | 7 | 4 | - | 20 | 0.5 | $5 \times 10^{-4}$ | 10 | 8 | 100/100 | ◎ | ○ |
| 2 | 87 | 13 | 4 | - | 20 | 0.5 | $1 \times 10^{-4}$ | 6 | 4 | 100/100 | ◎ | ○ |
| 3 | 90 | 10 | - | 3 | 20 | 0.5 | $2 \times 10^{-4}$ | 6 | 7 | 100/100 | ◎ | ○ |
| 4 | 90 | 10 | 6 | - | 20 | 0.5 | $3 \times 10^{-4}$ | 5 | 6 | 100/100 | ◎ | ○ |
| 5 | 90 | 10 | 4 | - | 5 | 0.5 | $6 \times 10^{-4}$ | 7 | 8 | 100/100 | ◎ | ○ |
| 6 | 90 | 10 | 4 | - | 45 | 0.5 | $4 \times 10^{-4}$ | 10 | 7 | 100/100 | ◎ | ○ |
| 7 | 90 | 10 | 4 | - | 20 | 0.3 | $2 \times 10^{-4}$ | 8 | 5 | 100/100 | ◎ | ○ |
| 8 | 90 | 10 | 4 | - | 20 | 2.0 | $5 \times 10^{-4}$ | 11 | 9 | 100/100 | ◎ | ○ |

TABLE 6

| comperative samples | COMPOSITION (PHR in weight) | | | | | | volume resistivity | resistance changing rate (%) | resistance changing rate (%) | adhesion | solderability | printability |
|---|---|---|---|---|---|---|---|---|---|---|---|---|
| | metallic copper powder | binder | dispersant | | metallic chelating agent | soldering accelerating agent | | | | | | |
| | weight % | (resin mixture) weight % | olein acid potassium | olein acid | triethanol amine | glutamic acid | (Ω·cm) | by hummidity cabinet test | by heating test | | | |
| 1 | 98 | 2 | 4 | - | 20 | 0.5 | - | - | - | - | - | x |
| 2 | 75 | 25 | 4 | - | 20 | 0.5 | $7 \times 10^{-4}$ | - | - | 100/100 | x | o |
| 3 | 90 | 10 | - | - | 20 | 0.5 | $5 \times 10^{-4}$ | 57 | 51 | 100/100 | o | o |
| 4 | 90 | 10 | 10 | - | 20 | 0.5 | $8 \times 10^{-4}$ | 37 | 23 | 10/100 | o | o |
| 5 | 90 | 10 | 4 | - | - | 0.5 | $5 \times 10^{-3}$ | 75 | 59 | 100/100 | △ | o |
| 6 | 90 | 10 | 4 | - | 55 | 0.5 | - | - | - | - | - | x |
| 7 | 90 | 10 | 4 | - | 20 | - | $2 \times 10^{-4}$ | 7 | 8 | 100/100 | o | o |
| 8 | 90 | 10 | 4 | - | 20 | 3.0 | $1 \times 10^{-3}$ | 126 | 131 | 100/100 | △ | △ |

## Claims

1. A printed circuit board for preventing emission of electromagnetic interference therefrom, comprising:
an electrically insulating base plate (12) having at least one main surface;
a first electrically conductive layer (14) formed on said main surface of said base plate, said first electrically conductive layer including a signal electrode portion in accordance with a desired circuit pattern; and
a second electrically conductive layer (22) formed so as to cover said first electrically conductive layer (14) and being electrically insulated from said signal electrode portion, wherein said first conductive layer (14) includes a ground electrode portion (14a) to which said second electrically conductive layer (22) is connected, said second electrically conductive layer (22) being arranged sufficiently close to the signal electrode portion of the first electrically conductive layer (14) that electromagnetic energy generated in said signal electrode portion of said first electrically conductive layer (14) is capacitively coupled to said second electrically conductive layer (22) and from there passes into said ground electrode portion (14a) such that electromagnetic interference is inhibited from radiating within said printed circuit board.

2. A printed circuit board in accordance with claim 1, further comprising an insulating layer (20) formed on said base plate (12) except for the part thereof with said ground electrode portion of said first electrically conductive layer, thereby insulating said signal electrode portion of said first electrically conductive layer (14) from said second electrically conductive layer (22).

3. A printed circuit board in accordance with claim 1 or 2, wherein said second electrically conductive layer (22) is formed so as to cover nearly the whole area of said main surface of said base plate (12).

4. A printed circuit board in accordance with claim 3, wherein said second electrically conductive layer (22) is formed of copper ink made by mixing copper powder, a binder and dispersant.

5. A printed circuit board in accordance with claim 4, wherein said binder is composed of a resin mixture including at least a thermosetting resin.

6. A printed circuit board in accordance with claim 4 or 5, wherein said dispersant includes a saturated or unsaturated fatty acid.

7. A printed circuit board in accordance with claim 4, 5 or 6, wherein said copper ink is made by blending 15 - 45 PHR in weight of a mixture of resol type phenol resin and p-tert-butyl phenol resin and 0.5 - 7 PHR in weight of unsaturated fatty acid or alkali metallic salt thereof with 100 PHR in weight of copper powder.

8. A printed circuit board in accordance with claim 7, wherein the blending ratio in weight of said resol type phenol resin and said p-tert-butyl phenol resin is 65:35 - 97:3.

9. A printed circuit board in accordance with any of claims 4 to 6, wherein said copper ink is made by blending 15 - 50 PHR in weight of resin mixture and 1 - 8 PHR in weight of saturated fatty acid or unsaturated fatty acid or metallic salt thereof with 100 PHR in weight of metallic copper powder.

10. A printed circuit board in accordance with claim 9, wherein said resin mixture is composed of 20 - 60 weight percent of melamine resin and 80 - 40 weight percent of polyol and polyester resin and/or alkyd resin.

11. A printed circuit board in accordance with claim 10, wherein the blending ratio in weight of said polyester resin and/or said alkyd resin and said polyol is 95 - 50: 5 - 50.

12. A printed circuit board in accordance with claim 1, 2 or 3, wherein second electrically conductive layer (22) is solderable and further comprising a solder layer (26) formed on said solderable second electrically conductive layer.

13. A printed circuit board in accordance with claim 12, wherein said solderable second electrically conductive layer (22) contains non-electrically conductive material that provides predetermined specific resistivity.

14. A printed circuit board in accordance with claim 13, wherein said solderable second electrically conductive

layer (22) includes copper powder.

**15.** A printed circuit board in accordance with claim 14, wherein said solderable second electrically conducting layer (22) is formed by a copper ink which is made by mixing metallic copper powder, resin mixture, saturated fatty acid or unsaturated fatty acid or metallic salt thereof and a metallic chelating agent.

**16.** A printed circuit board in accordance with claim 15, wherein said copper ink further includes a soldering accelerating agent.

**17.** A printed circuit board in accordance with claim 15 or 16, wherein said resin mixture is made by mixing metal surface activating resin and thermosetting resin.

**18.** A printed circuit board in accordance with claim 15, 16 or 17 wherein said copper ink is composed of a total of 100 PHR in weight of 85 - 95 weight percent of metallic copper powder and 15 - 5 weight percent of resin mixture, 1 - 8 PHR in weight of fatty acid or metallic salt thereof, 1 - 50 PHR in weight of metallic chelating agent and 0.1 - 2.5 PHR in weight of soldering accelerating agent.

**19.** A printed circuit board in accordance with claim 18, wherein said resin mixture includes 2 - 30 weight percent of metal surface activating resin and the remainder being thermosetting resin.

**20.** A printed circuit board in accordance with any preceding claim wherein said base plate (12) has an additional electrically insulated main surface and wherein said additional said first (14) and second (22) electrically conductive layers are formed on said additional electrically insulated main surface.

**21.** A printed cricuit board in accordance with any preceding claim, further comprising an insulating layer (24) covering the or each said second electrically conductive layers (22).

**22.** A printed circuit board according to any one of claims 4 to 11 and 15 to 19, wherein said copper ink includes a corrosion reducing agent.

**23.** A method of manufacturing a printed circuit board capable of preventing electromagnetic interference, comprising:

(a) forming in accordance with a desired circuit pattern a first electrically conductive layer (14) including a signal electrode portion on at least one of the main surfaces of a base plate (12) composed of an insulating material; and

(b) forming a second electrically conductive layer (22) so as to cover said first electrically conductive layer and being electrically insulated from said signal electrode portion, wherein the first conductive layer (14) includes a ground electrode portion (14a) to which said second electrically conductive layer is connected, said second electrically conductive layer (22) being arranged sufficiently close to the signal electrode portion of the first electrically conductive layer (14) that electromagnetic energy generated in said signal electrode portion of said first electrically conductive layer (14) is capacitively coupled to said second electrically conductive layer (22) and from there passes into said ground electrode portion (14a) such that electromagnetic interference is inhibited from radiating within said printed circuit board.

**24.** A method of manufacturing a printed circuit board in accordance with claim 23, wherein after forming said first electrically conductive layer (14) and before forming said electrically conductive layer (22), an insulating layer (20) is formed overlying said base plate (12) except for over said ground electrode portion (14a), said ground electrode portion is exposed so that said second electrically conductive layer contacts said ground electrode portion.

**25.** A method of manufacturing a printed circuit board capable of preventing electromagnetic interference in accordance with claim 23 or 24, wherein said step (b) includes a step of printing a copper ink made by mixing metallix copper powder, binder resin and a dispersant, so as to cover said first electrically conductive layer (14) and being electrically insulated from said signal electrode portion, and which further includes a step of curing said printed copper ink to form a copper ink layer as said second electrically conductive layer (22).

**26.** A method of manufacturing a printed circuit board capable of preventing electromagnetic intereference in accordance with claim 25, wherein said binder resin includes a thermosetting resin, and said step of

curing said copper ink includes a step of heating said printed copper ink.

27. A method according to any one of claims 23 to 26 including forming a solder layer (26) on said second electrically conductive layer by means of soldering.

## Patentansprüche

1. Leiterplatte zum Vermeiden der Emission von elektromagnetischer Interferenz hiervon, mit:
einer elektrisch isolierenden Grundplatte (12) mit mindestens einer Hauptoberfläche;
einer ersten elektrisch leitenden Schicht (14), die auf der Hauptoberfläche der Grundplatte ausgebildet ist, wobei die erste elektrisch leitende Schicht einen Signalelektrodenabschnitt gemäß einem gewünschten Schaltungsmuster umfaßt; und
einer zweiten elektrisch leitenden Schicht (22), die derart ausgebildet ist, daß sie die erste elektrisch leitende Schicht (14) bedeckt und von dem Signalelektrodenabschnitt elektrisch isoliert ist, wobei die erste leitende Schicht (14) einen Masseelektrodenabschnitt (14a) umfaßt, mit dem die zweite elektrisch leitende Schicht (22) verbunden ist, und wobei die zweite elektrisch leitende Schicht (22) nahe genug bei dem Signalelektrodenabschnitt der ersten elektrisch leitenden Schicht (14) angeordnet ist, daß in dem Signalelektrodenabschnitt der ersten elektrisch leitenden Schicht (14) erzeugte elektromagnetische Energie kapazitiv in die zweite elektrisch leitende Schicht (22) gekoppelt und von dort in den Masseelektrodenabschnitt (14a) weitertransportiert wird, so daß verhindert wird, daß elektromagnetische Interferenz in der Leiterplatte abgestrahlt wird.

2. Leiterplatte nach Anspruch 1, die des weiteren eine isolierende Schicht (20) aufweist, welche auf der Grundplatte (12) mit Ausnahme von deren Teil mit dem Masseelektrodenabschnitt der ersten elektrisch leitenden Schicht ausgebildet ist, wodurch der Signalelektrodenabschnitt der ersten elektrisch leitenden Schicht (14) von der zweiten elektrisch leitenden Schicht (22) isoliert ist.

3. Leiterplatte nach Anspruch 1 oder 2, bei der die zweite elektrisch leitende Schicht (22) derart ausgebildet ist, daß sie nahezu die ganze Fläche der Hauptoberfläche der Grundplatte (12) bedeckt.

4. Leiterplatte nach Anspruch 3, bei der die zweite elektrisch leitende Schicht (22) aus Kupferfarbe gebildet ist, die durch Mischen von Kupferpulver, eines Bindemittels und eines Dispersionsmittels hergestellt ist.

5. Leiterplatte nach Anspruch 4, bei der das Bindemittel aus einer Harzmischung zusammengesetzt ist, die zumindest ein wärmeaushärtbares Harz enthält.

6. Leiterplatte nach Anspruch 4 oder 5, bei der das Dispersionsmittel eine gesättigte oder ungesättigte Fettsäure enthält.

7. Leiterplatte nach Anspruch 4, 5 oder 6, bei der die Kupferfarbe durch Mischen von bezogen auf das Gewicht 15 - 45 PHR einer Mischung aus Phenolharz vom Resoltyp und p-tert-Butyl-Phenolharz und von bezogen auf das Gewicht 0,5 - 7 PHR an ungesättigter Fettsäure oder Alkalimetallsalz davon mit bezogen auf das Gewicht 100 PHR an Kupferpulver hergestellt ist.

8. Leiterplatte nach Anspruch 7, bei der das auf das Gewicht bezogene Mischungsverhältnis des Phenolharzes vom Resoltyp und des p-tert-Butyl-Phenolharzes 65:35 - 97:3 beträgt.

9. Leiterplatte nach einem der Ansprüche 4 bis 6, bei der die Kupferfarbe durch Vermischen von bezogen auf das Gewicht 15 - 50 PHR an Harzmischung und bezogen auf das Gewicht 1 - 8 PHR an gesättigter Fettsäure oder ungesättigter Fettsäure oder Metallsalz davon mit bezogen auf das Gewicht 100 PHR an metallischem Kupferpulver hergestellt ist.

10. Leiterplatte nach Anspruch 9, bei der das Harzgemisch aus 20 - 60 Gew.-% Melaminharz und 80 - 40 Gew.-% Polyol und Polyesterharz und/oder Alkydharz zusammengesetzt ist.

11. Leiterplatte nach Anspruch 10, bei der das auf das Gewicht bezogene Mischungsverhältnis des Polyesterharzes und/oder des Alkydharzes und des Polyols 95 - 50 : 5 - 50 beträgt.

12. Leiterplatte nach Anspruch 1, 2 oder 3, bei der die zweite elektrisch leitende Schicht (22) lötbar ist und

die des weiteren eine Lötmittelschicht (26) aufweist, die auf der lötbaren zweiten elektrisch leitenden Schicht ausgebildet ist.

**13.** Leiterplatte nach Anspruch 12, bei der die lötbare zweite elektrisch leitende Schicht (22) elektrisch nicht leitendes Material enthält, das einen festgelegten spezifischen Widerstand liefert.

**14.** Leiterplatte nach Anspruch 13, bei dem die lötbare zweite elektrisch leitende Schicht (22) Kupferpulver enthält.

**15.** Leiterplatte nach Anspruch 14, bei der die lötbare zweite elektrisch leitende Schicht (22) aus einer Kupferfarbe gebildet ist, die durch Vermischen von metallischem Kupferpulver, Harzgemisch, gesättigter Fettsäure oder ungesättigter Fettsäure oder Metallsalz davon und einem metallischen chelatbildenden Mittel hergestellt ist.

**16.** Leiterplatte nach Anspruch 15, bei der die Kupferfarbe des weiteren ein das Löten beschleunigendes Mittel enthält.

**17.** Leiterplatte nach Anspruch 15 oder 16, bei der das Harzgemisch durch Vermischen von metallgrenzflächenaktivem Harz und wärmeaushärtbarem Harz hergestellt ist.

**18.** Leiterplatte nach Anspruch 15, 16 oder 17, bei der die Kupferfarbe aus bezogen auf das Gewicht insgesamt 100 PHR an 85 - 95 Gew.-% metallischem Kupferpulver und an 15 - 5 Gew.-% Harzgemisch, bezogen auf das Gewicht 1 - 8 PHR Fettsäure oder Metallsalz davon, bezogen auf das Gewicht 1 - 50 PHR an metallischem chelatbildendem Mittel und bezogen auf das Gewicht 0,1 - 2,5 PHR an das Löten beschleunigendem Mittel zusammengesetzt ist.

**19.** Leiterplatte nach Anspruch 18, bei der das Harzgemisch 2 - 30 Gew.-% metallgrenzflächenaktives Harz enthält, wobei der Rest wärmeaushärtbares Harz ist.

**20.** Leiterplatte nach einem der vorhergehenden Ansprüche, bei der die Grundplatte (12) eine zusätzliche elektrisch isolierte Hauptoberfläche aufweist, und bei der die zusätzliche erste (14) und zweite (22) elektrisch leitende Schicht auf der zusätzlichen elektrisch isolierten Hauptoberfläche ausgebildet sind.

**21.** Leiterplatte nach einem der vorhergehenden Ansprüche, die des weiteren eine isolierende Schicht (24) aufweist, die die zweite(n) elektrisch leitende(n) Schicht(en) (22) bedeckt.

**22.** Leiterplatte nach einem der Ansprüche 4 bis 11 oder 5 bis 19, bei der die Kupferfarbe ein korrosionsverminderndes Mittel enthält.

**23.** Verfahren zur Herstellung einer Leiterplatte, die elektromagnetische Interferenz verhindern kann, welches folgende Schritte aufweist:

(a) Gemäß einem gewünschten Schaltungsmuster Bilden einer elektrisch leitenden Schicht (14), die auf mindestens einer der beiden Hauptoberflächen einer aus einem isolierenden Stoff zusammengesetzten Grundplatte (12) einen Signalelektrodenabschnitt umfaßt; und

(b) Bilden einer zweiten elektrisch leitenden Schicht (22) derart, daß sie die erste elektrisch leitende Schicht (14) bedeckt und von dem Signalelektrodenabschnitt elektrisch isoliert ist, wobei die erste leitende Schicht (14) einen Masseelektrodenabschnitt (14a) umfaßt, mit dem die zweite elektrisch leitende Schicht (22) verbunden ist, und wobei die zweite elektrisch leitende Schicht (22) nahe genug bei dem Signalelektrodenabschnitt der ersten elektrisch leitenden Schicht (14) angeordnet ist, daß in dem Signalelektrodenabschnitt der ersten elektrisch leitenden Schicht (14) erzeugte elektromagnetische Energie kapazitiv in die zweite elektrisch leitende Schicht (22) gekoppelt und von dort in den Masseelektrodenabschnitt (14a) weitertransportiert wird, so daß verhindert wird, daß elektromagnetische Interferenz in der Leiterplatte abgestrahlt wird.

**24.** Verfahren zur Herstellung einer Leiterplatte nach Anspruch 23, bei dem nach der Bildung der ersten elektrisch leitenden Schicht (14) und vor der Bildung der elektrisch leitenden Schicht (22) eine isolierende Schicht (20) gebildet wird, die die Grundplatte (12) mit Ausnahme über dem Masseelektrodenabschnitt (14a) überdeckt, wobei der Masseelelektrodenabschnitt so freigelegt ist, daß die zweite elektrisch leitende Schicht mit dem Masseelektrodenabschnitt in Kontakt steht.

**25.** Verfahren zur Herstellung einer Leiterplatte, die elektromagnetische Interferenz vermeiden kann, nach Anspruch 23 oder 24, bei dem der Schritt (b) einen Schritt des Druckens einer durch Mischen von metallischem Kupferpulver, Bindeharz und einem Dispersionsmittel hergestellten Kupferfarbe umfaßt, so daß sie die erste elektrisch leitende Schicht (14) bedeckt und von dem Signalelektrodenabschnitt elektrisch isoliert ist, und das des weiteren einen Schritt des Härtens der gedruckten Kupferfarbe umfaßt, um eine Kupferfarbschicht als zweite elektrisch leitende Schicht (22) zu bilden.

**26.** Verfahren zur Herstellung einer Leiterplatte, die elektromagnetische Interferenz vermeiden kann, nach Anspruch 25, bei dem das Bindeharz ein wärmeaushärtbares Harz enthält und der Schritt des Härtens der Kupferfarbe einen Schritt der Erhitzung der gedruckten Kupferfarbe umfaßt.

**27.** Verfahren nach einem der Ansprüche 23 bis 26, das die Bildung einer Lötmittelschicht (26) auf der zweiten elektrisch leitenden Schicht mittels Löten umfaßt.

## Revendications

**1.** Une carte de circuit imprimé conçue pour éviter l'émission de perturbations électromagnétiques à partir de la carte, comprenant :
une plaque de base électriquement isolante (12) ayant au moins une surface principale;
une première couche électriquement conductrice (14) formée sur la surface principale de la plaque de base, cette première couche électriquement conductrice ayant une partie d'électrode de signal qui correspond à une configuration de circuit désirée; et
une seconde couche électriquement conductrice (22) formée de façon à recouvrir la première couche électriquement conductrice (14), et étant électriquement isolée de la partie d'électrode de signal, dans laquelle la première couche conductrice (14) comprend une partie d'électrode de masse (14a) à laquelle la seconde couche électriquement conductrice (22) est connectée, la seconde couche électriquement conductrice (22) étant disposée suffisamment près de la partie d'électrode de signal de la première couche électriquement conductrice (14) pour que l'énergie électromagnétique qui est générée dans la partie d'électrode de signal de la première couche électriquement conductrice (14) soit couplée de façon capacitive à la seconde couche électriquement conductrice (22), et passe de celle-ci dans la partie d'électrode de masse (14a), de manière à empêcher le rayonnement d'une perturbation électromagnétique dans la carte de circuit imprimé.

**2.** Une carte de circuit imprimé selon la revendication 1, comprenant en outre une couche isolante (20) formée sur la plaque de base (12), sauf dans la région de celle-ci dans laquelle se trouve la partie d'électrode de masse de la première couche électriquement conductrice, pour isoler ainsi la partie d'électrode de signal de la première couche électriquement conductrice (14) vis-à-vis de la seconde couche électriquement conductrice (22).

**3.** Une carte de circuit imprimé selon la revendication 1 ou 2, dans laquelle la seconde couche électriquement conductrice (22) est formée de façon à recouvrir presque la totalité de l'étendue de la surface principale de la plaque de base (12).

**4.** Une carte de circuit imprimé selon la revendication 3, dans laquelle la seconde couche électriquement conductrice (22) est formée par une encre contenant du cuivre, qui est obtenue en mélangeant de la poudre de cuivre, un liant et un dispersant.

**5.** Une carte de circuit imprimé selon la revendication 4, dans laquelle le liant est constitué par un mélange de résines contenant au moins une résine thermodurcissable.

**6.** Une carte de circuit imprimé selon la revendication 4 ou 5, dans laquelle le dispersant contient un acide gras saturé ou insaturé.

**7.** Une carte de circuit imprimé selon la revendication 4, 5 ou 6, dans laquelle l'encre contenant du cuivre est obtenue en mélangeant 15-45 parties en poids, pour 100 parties en poids de résine, d'un mélange de résine de phénol du type résol et de résine de p-tertiobutylphénol, et 0,5-7 parties en poids, pour 100 parties en poids de résine, d'un acide gras insaturé ou d'un sel de métal alcalin de cet acide, avec 100 parties en poids, pour 100 parties en poids de résine, de poudre de cuivre.

8. Une carte de circuit imprimé selon la revendication 7, dans laquelle le rapport de mélange en poids de la résine de phénol de type résol et de la résine de p-tertiobutylphénol est de 65:35 - 97:3.

9. Une carte de circuit imprimé selon l'une quelconque des revendications 4 à 6, dans laquelle l'encre contenant du cuivre est formée en mélangeant 15-50 parties en poids, pour 100 parties en poids de résine, de mélange de résines et 1-8 parties en poids, pour 100 parties en poids de résine, d'un acide gras saturé ou d'un acide gras insaturé ou d'un sel métallique de cet acide avec 100 parties en poids, pour 100 parties en poids de résine, de poudre de cuivre métallique.

10. Une carte de circuit imprimé selon la revendication 9, dans laquelle le mélange de résines est composé de 20-60 pour cent en poids de résine de mélamine et de 80-40 pour cent en poids de polyol et de résine de polyester et/ou de résine alkyde.

11. Une carte de circuit imprimé selon la revendication 10, dans laquelle le rapport de mélange en poids de la résine de polyester et/ou de la résine alkyde et du polyol est de 95-50:5-50.

12. Une carte de circuit imprimé selon la revendication 1, 2 ou 3, dans laquelle la seconde couche électriquement conductrice (22) se prête au brasage et il existe en outre une couche de brasure (26) formée sur la seconde couche électriquement conductrice se prêtant au brasage.

13. Une carte de circuit imprimé selon la revendication 12, dans laquelle la seconde couche électriquement conductrice (22) se prêtant au brasage contient une matière non conductrice de l'électricité qui procure une résistivité prédéterminée.

14. Une carte de circuit imprimé selon la revendication 13, dans laquelle la seconde couche électriquement conductrice (22) se prêtant au brasage contient une poudre de cuivre.

15. Une carte de circuit imprimé selon la revendication 14, dans laquelle la seconde couche électriquement conductrice (22) se prêtant au brasage est formée par une encre contenant du cuivre qui est obtenue en mélangeant une poudre de cuivre métallique, un mélange de résines, un acide gras saturé ou un acide gras insaturé ou un sel métallique de cet acide et un agent chélatant métallique.

16. Une carte de circuit imprimé selon la revendication 15, dans laquelle l'encre contenant du cuivre contient en outre un agent d'accélération du brasage.

17. Une carte de circuit imprimé selon la revendication 15 ou 16, dans laquelle le mélange de résines est formé en mélangeant une résine d'activation de surface métallique et une résine thermodurcissable.

18. Une carte de circuit imprimé selon la revendication 15, 16 ou 17, dans laquelle l'encre contenant du cuivre est composée par un total de 100 parties en poids, pour 100 parties en poids de résine, de 85-95 pour cent en poids de poudre de cuivre métallique et de 15-5 pour cent en poids de mélange de résines, 1-8 parties en poids, pour 100 parties en poids de résine, d'acide gras ou de sel métallique de cet acide, 1-50 parties en poids, pour 100 parties en poids de résine, d'agent chélatant métallique et 0,1-2,5 parties en poids, pour 100 parties en poids de résine, d'agent d'accélération du brasage.

19. Une carte de circuit imprimé selon la revendication 18, dans laquelle le mélange de résines contient 2-30 pour cent en poids de résine d'activation de surface métallique, le reste consistant en résine thermodurcissable.

20. Une carte de circuit imprimé selon l'une quelconque des revendications précédentes, dans laquelle la plaque de base (12) comporte une surface principale électriquement isolée supplémentaire, et dans laquelle les première (14) et seconde (22) couches électriquement conductrices sont formées sur cette surface principale électriquement isolée supplémentaire.

21. Une carte de circuit imprimé selon l'une quelconque des revendications précédentes, comprenant en outre une couche isolante (24) qui recouvre la seconde couche électriquement conductrice (22), ou chacune d'elles.

22. Une carte de circuit imprimé selon l'une quelconque des revendications 4 à 11 et 15 à 19, dans laquelle l'encre contenant du cuivre contient un agent de réduction de corrosion.

**23.** Un procédé de fabrication d'une carte de circuit imprimé capable d'éviter des perturbations électromagnétiques, comprenant

(a) la formation, conformément à une configuration de circuit désirée, d'une première couche électriquement conductrice (14) comprenant une partie d'électrode de signal sur l'une au moins des surfaces principales d'une plaque de base (12) constituée par un matériau isolant; et

(b) la formation d'une seconde couche électriquement conductrice (22) de façon à recouvrir la première couche électriquement conductrice et de façon qu'elle soit électriquement isolée de la partie d'électrode de signal, la première couche conductrice (14) comprenant une partie d'électrode de masse (14a) à laquelle la seconde couche électriquement conductrice est connectée, cette seconde couche électriquement conductrice (22) étant disposée suffisamment près de la partie d'électrode de signal de la première couche électriquement conductrice (14) pour que l'énergie électromagnétique qui est générée dans la partie d'électrode de signal de la première couche électriquement conductrice (14) soit couplée de façon capacitive à la seconde couche électriquement conductrice (22) et passe à partir de là dans la partie d'électrode de masse (14a) de façon à empêcher le rayonnement d'une perturbation électromagnétique dans la carte de circuit imprimé.

**24.** Un procédé de fabrication d'une carte de circuit imprimé selon la revendication 23, dans lequel après la formation de la première couche électriquement conductrice (14), et avant la formation de la seconde couche électriquement conductrice (22), une couche isolante (20) est formée de façon à recouvrir la plaque de base (12) à l'exception de la région située au-dessus de la partie d'électrode de masse (14a), cette partie d'électrode de masse étant à nu de façon que la seconde couche électriquement conductrice vienne en contact avec la partie d'électrode de masse.

**25.** Un procédé de fabrication d'une carte de circuit imprimé capable d'éviter des perturbations électromagnétiques selon la revendication 23 ou 24, dans lequel l'étape (b) comprend une étape d'impression d'une encre contenant du cuivre qui est formée en mélangeant une poudre de cuivre métallique, une résine constituant un liant et un dispersant, de façon à recouvrir la première couche électriquement conductrice (14), cette encre étant électriquement isolée de la partie d'électrode de signal, et elle comprend en outre une étape de durcissement de l'encre contenant du cuivre qui a été imprimée, pour former une couche d'encre contenant du cuivre pour la seconde couche électriquement conductrice (22).

**26.** Un procédé de fabrication d'une carte de circuit imprimé capable d'éviter des perturbations électromagnétiques selon la revendication 25, dans lequel la résine constituant un liant contient une résine thermodurcissable, et l'étape de durcissement de l'encre contenant du cuivre comprend une étape de chauffage de l'encre contenant du cuivre qui a été imprimée.

**27.** Un procédé selon l'une quelconque des revendications 23 à 26, comprenant la formation d'une couche de brasure (26) sur la seconde couche électriquement conductrice, par une opération de brasage.

FIG.1

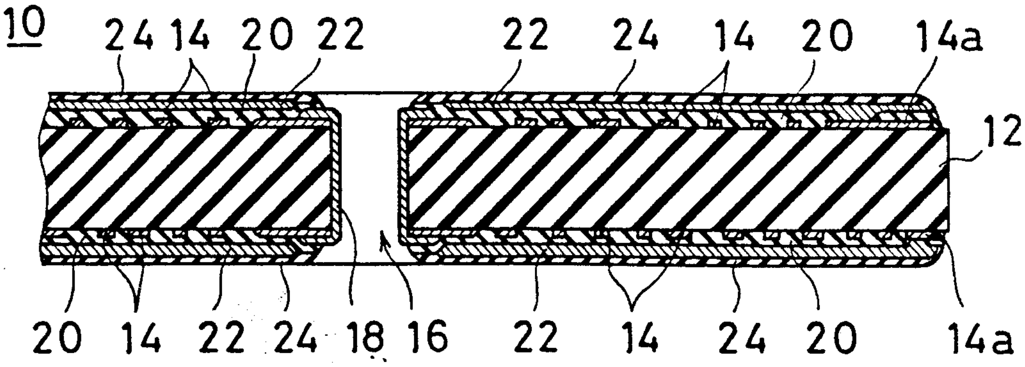


FIG.2

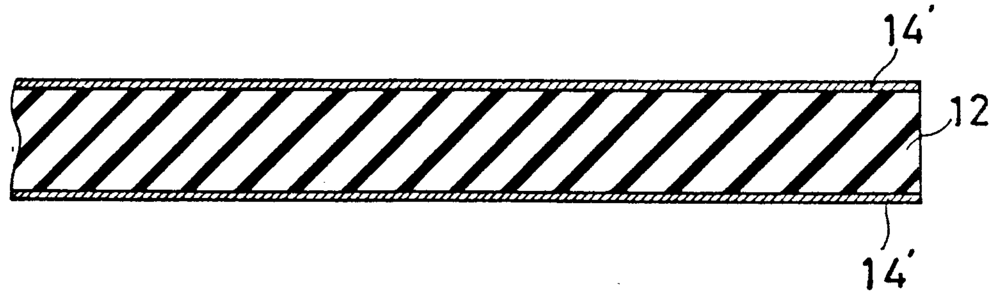


FIG.3

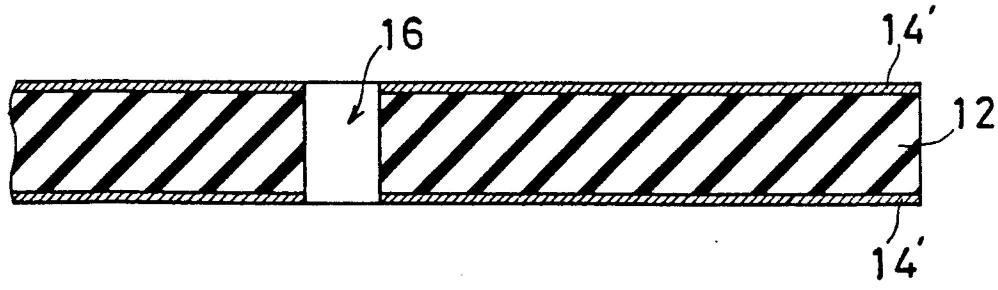

F I G.4

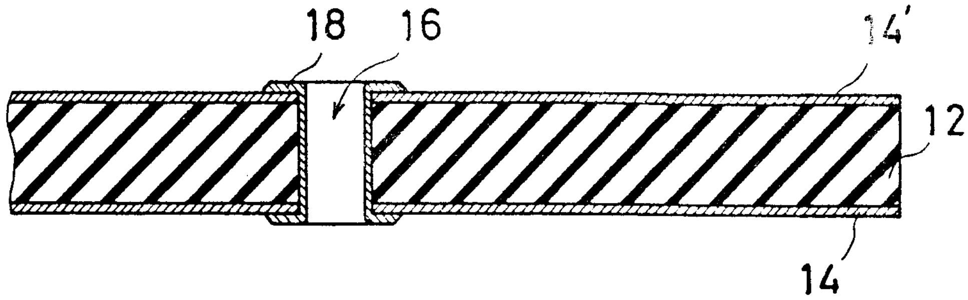


F I G.5

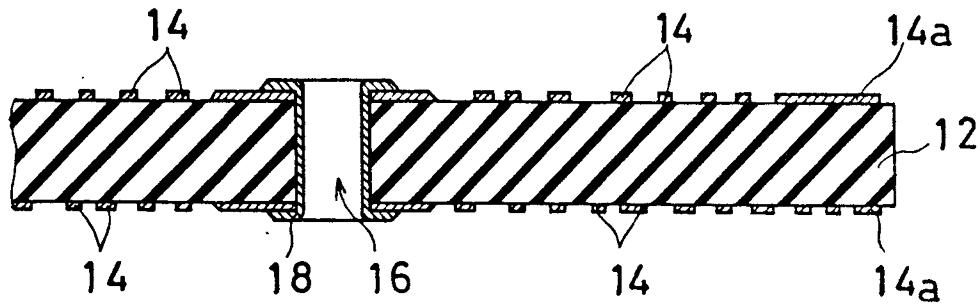


F I G.6

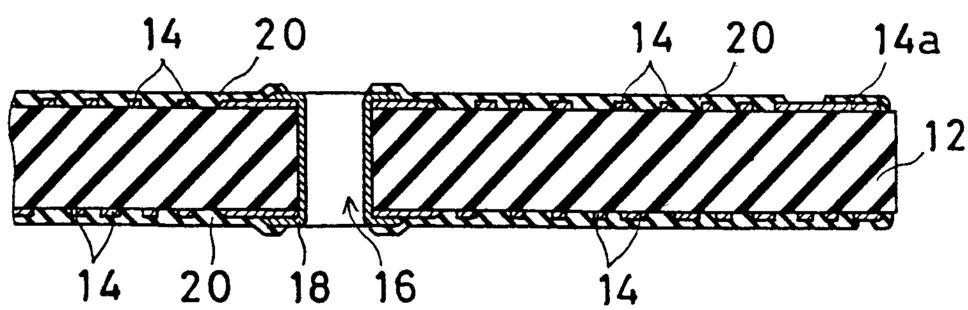

FIG. 7

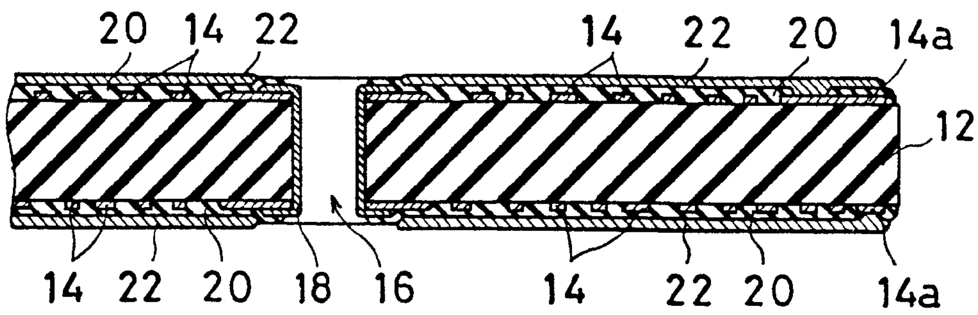


FIG. 8

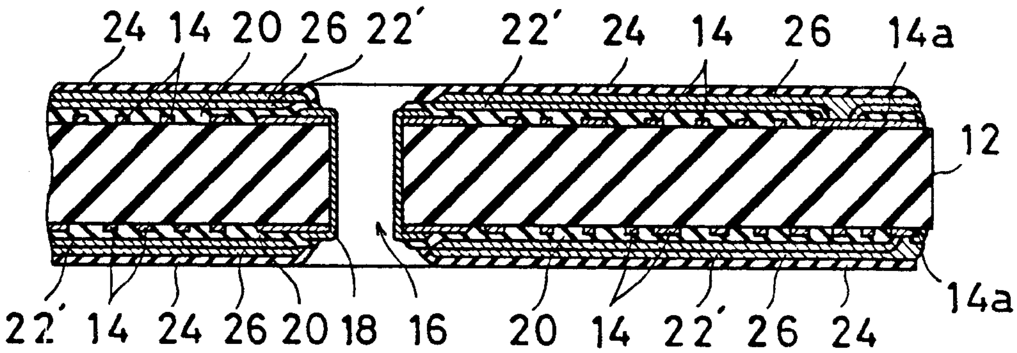


FIG. 9

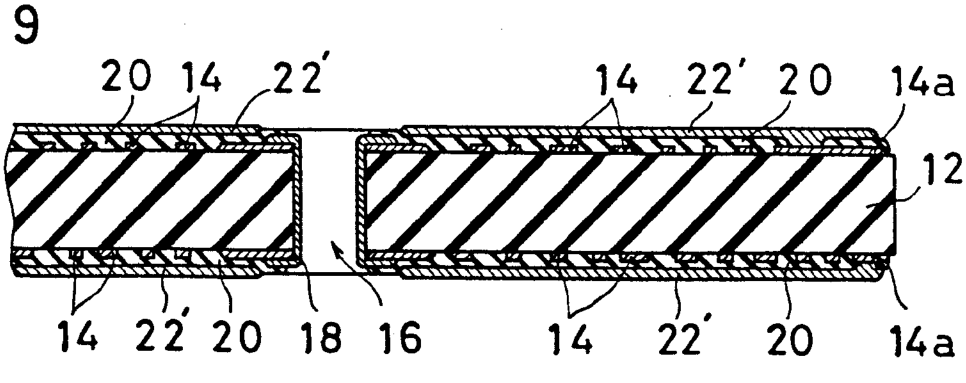

FIG.10

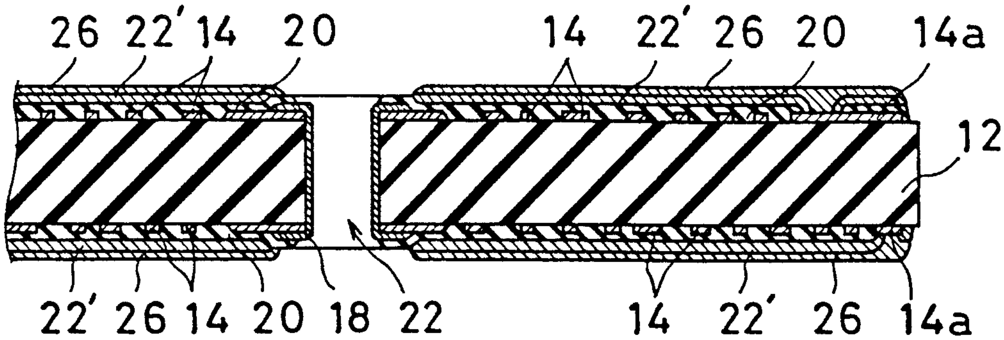


FIG.11

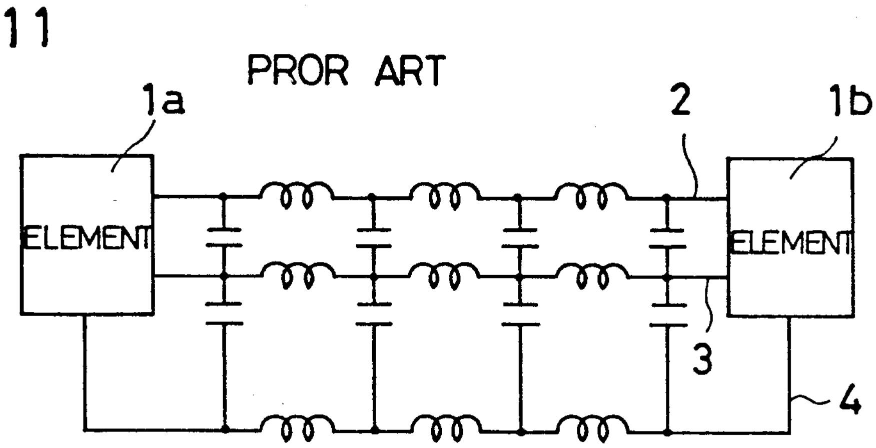


FIG.12

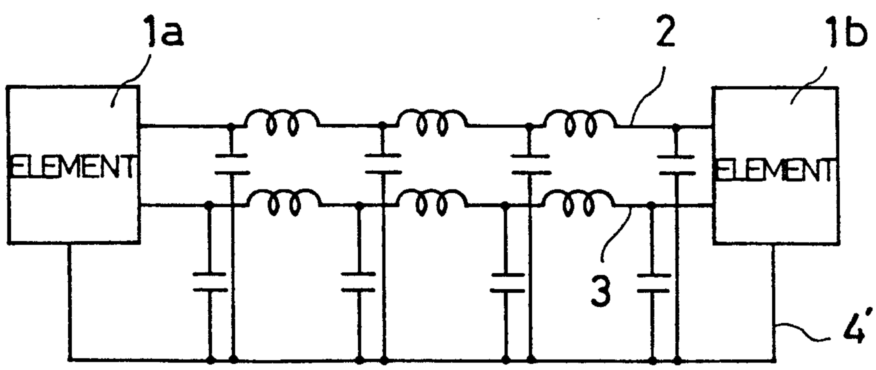

FIG.13

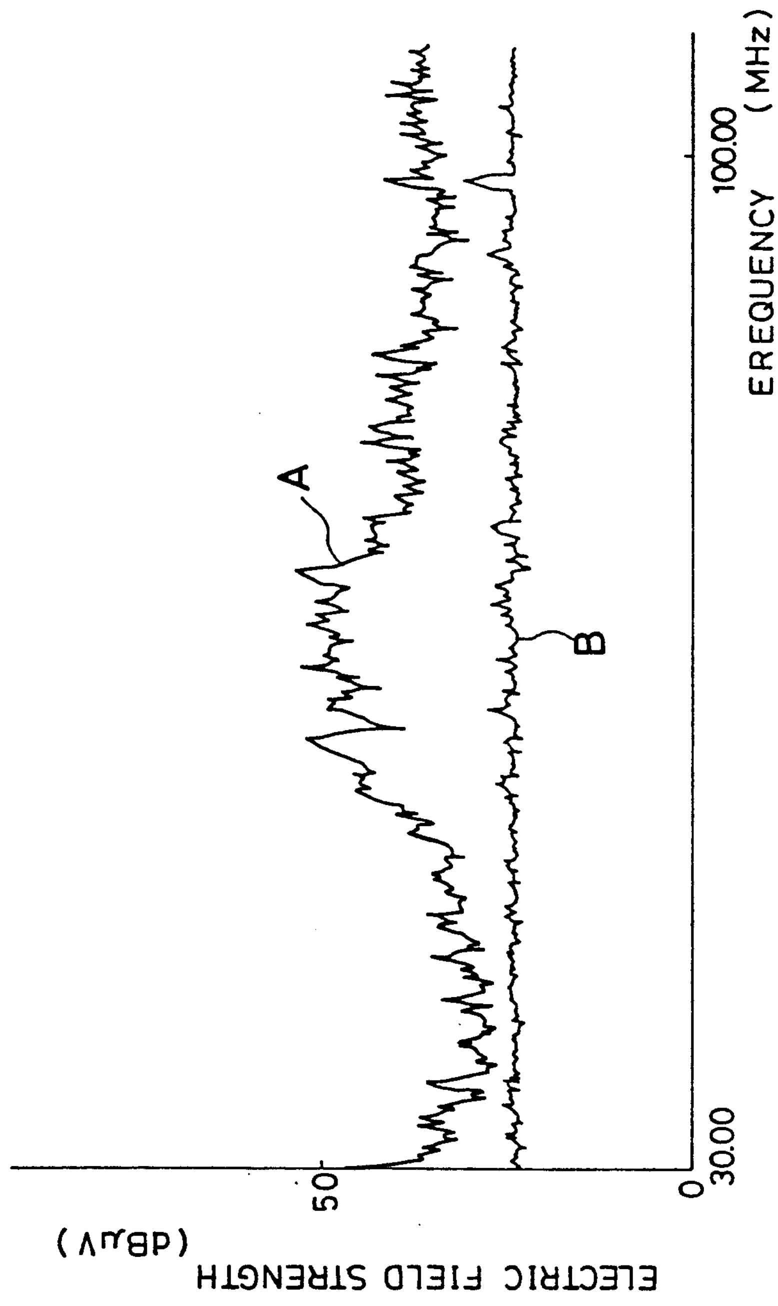
ELECTRIC FIELD STRENGTH (dBμV)
50
0
30.00
100.00
EREQUENCY (MHz)
A
B